# EUROPEAN PATENT APPLICATION

(11) **EP 4 312 273 A1**
(43) Date of publication of application: **31.01.2024**
(21) Application number: 23167342.7
(22) Date of filing: 11.04.2023
(51) Int. Cl.: H01L 27/15, H01L 25/16, H01L 33/00, H01L 33/14, H01L 33/62, H01L 33/08

(54) **LIGHT EMITTING STRUCTURE, DISPLAY APPARATUS, AND METHOD OF MANUFACTURING THE DISPLAY APPARATUS**

(30) Priority: 28.07.2022 KR 20220094026
(71) Applicant: Samsung Electronics Co., Ltd., Suwon-si, Gyeonggi-do 16677 (KR)
(72) Inventor: CHOI, Junhee, 16678, Suwon-si, (KR); KONG, Kiho, 16678, Suwon-si, (KR); KIM, Joosung, 16678, Suwon-si, (KR); PARK, Younghwan, 16678, Suwon-si, (KR); PARK, Jinjoo, 16678, Suwon-si, (KR); SHIN, Dongchul, 16678, Suwon-si, (KR)
(74) Representative: Elkington and Fife LLP

(57) **Abstract**

A light emitting structure includes: a substrate; a first epitaxial structure disposed on the substrate; a second epitaxial structure disposed on the first epitaxial structure; and a third epitaxial structure disposed on the second epitaxial structure. Each of the first epitaxial structure, the second epitaxial structure, and the third epitaxial structure comprises, in a sequentially stacked structure, a first semiconductor layer of a first conductivity, a carrier blocking layer, an active layer, and a second semiconductor layer of a second conductivity.

## Description

### FIELD OF THE INVENTION

The disclosure relates to a light emitting structure, a display apparatus, and a manufacturing method of the display apparatus, and more particularly, to a light emitting structure having a vertical stack epitaxial structure, a display apparatus, and a manufacturing method of the display apparatus.

### BACKGROUND OF THE INVENTION

Currently, liquid crystal displays (LCDs) and organic light emitting diode (OLED) displays are widely used as display apparatuses. Recently, technology for manufacturing a high-resolution display apparatus using micro light emitting diodes (LEDs) has become an area of interest. However, in order to manufacture a high-resolution display apparatus using micro LEDs, improved high-efficiency micro LED chips should be manufactured, and an improved high-level transfer technology is desirable to arrange the micro LED chips in an appropriate position.

### SUMMARY OF THE INVENTION

Provided are a light emitting structure having a vertical stack epitaxial structure, a high-resolution display apparatus, and a method of manufacturing the display apparatus.

Provided are a high-resolution display apparatus including a plurality of monolithic light emitting devices and a method of manufacturing the same.

Additional aspects will be set forth in part in the description which follows and, in part, will be apparent from the description, or may be learned by practice of the presented embodiments of the disclosure.

A light emitting structure may include: a substrate; a first epitaxial structure disposed on the substrate; a second epitaxial structure disposed on the first epitaxial structure; and a third epitaxial structure disposed on the second epitaxial structure. Each of the first epitaxial structure, the second epitaxial structure, and the third epitaxial structure may include, in a sequentially stacked structure, a first semiconductor layer of a first conductivity, a carrier blocking layer, an active layer, and a second semiconductor layer of a second conductivity.

The carrier blocking layer may include a hole blocking layer.

Each of the first epitaxial structure, the second epitaxial structure, and the third epitaxial structure may further include an electron blocking layer between the active layer and the second semiconductor layer.

The light emitting structure may further include a first junction layer and a second junction layer each doped with a high concentration to have the first conductivity, respectively between the first epitaxial structure and the second epitaxial structure, and between the second epitaxial structure and the third epitaxial structure.

The active layer of each of the first epitaxial structure, the second epitaxial structure, and the third epitaxial structure may be configured to emit light at different wavelengths.

A display apparatus may include: a plurality of light emitting devices including a first surface from which light is emitted; and a plurality of mesa structures spaced apart from each other on a second surface opposite to the first surface, each of the mesa structures being configured to emit light of different wavelengths. The plurality of mesa structures may include a first mesa structure including a first epitaxial structure, and at least one second mesa structure each including a vertical stack of the first epitaxial structure and at least one second epitaxial structure, such that at least two of the plurality of mesa structures have different heights. Each of the first epitaxial structure and the at least one second epitaxial structure may have a sequential stack structure of a first semiconductor layer of a first conductivity, a carrier blocking layer, an active layer, and a second semiconductor layer of a second conductivity in a direction away from the first surface, such that the carrier blocking layer is configured to block a carrier moving from the second semiconductor layer toward the first semiconductor layer; each of the plurality of mesa structures being configured to generate colored light of a corresponding light emitting device in the active layer of the epitaxial structure farthest from the first surface, the active layer of the first epitaxial structure and the active layer of each of the at least one second epitaxial structure being configured to generate light of different wavelengths. The first surface may correspond to one surface of the first semiconductor layer of the first epitaxial structure. The plurality of light emitting devices may be formed in a monolithic shape connected through a partial thickness part of the first semiconductor layer of the first epitaxial structure.

The carrier blocking layer may include a hole blocking layer.

Each of the first epitaxial structure and each of the at least one second epitaxial structure may further include an electron blocking layer between the active layer and the second semiconductor layer.

The display apparatus may further include a junction layer doped with a high concentration to have the first conductivity between the second semiconductor layer of the first epitaxial structure and the first semiconductor layer of second epitaxial structure of the at least one second epitaxial structure adjacent to the first epitaxial structure, and between the second semiconductor layer of the second epitaxial structure adjacent to the first epitaxial structure and the first semiconductor layer of any second semiconductor of the at least one second semiconductor layer that is adjacent, wherein a tunnel junction is formed between any of the first epitaxial structure and the at least one of the second epitaxial structure that are adjacent to each other in a vertical direction.

The display apparatus of may further include a plurality of driving transistors that are each electrically connected to each of the corresponding plurality of mesa structures to drive each of the corresponding plurality of light emitting devices.

The plurality of driving transistors may be formed in a monolithic manner with the plurality of light emitting devices.

The display apparatus may further include a common electrode disposed on the first surface.

The common electrode may be patterned to form, on the first surface, a plurality of opening regions configured to emit light generated from the plurality of light emitting devices.

The display apparatus may further include a light extraction pattern in at least a portion of the plurality of opening regions.

Each of the plurality of mesa structures may further include a first electrode in contact with the second semiconductor layer of the first epitaxial structure or the at least one of the second epitaxial structure that is farthest from the first surface.

The first electrode may include a transparent electrode disposed on a surface of the second semiconductor layer.

The width of each of the plurality of mesa structures may be in the range of 0.1 µm to 100 µm.

An augmented reality apparatus may include: a projection system including a display apparatus configured to generate an image; and an optical system for guiding the image from the projection system to a user's eyes. The display apparatus may include: a plurality of light emitting devices including a first surface from which light is emitted; and a plurality of mesa structures spaced apart from each other on a second surface opposite to the first surface, each of the mesa structures being configured to emit light of different wavelengths. The plurality of mesa structures may include a first mesa structure including a first epitaxial structure, and at least one second mesa structure each including a vertical stack of the first epitaxial structure and at least one second epitaxial structure, such that at least two of the plurality of mesa structures have different heights. Each of the first epitaxial structure and the at least one second epitaxial structure may have a sequential stack structure of a first semiconductor layer of a first conductivity, a carrier blocking layer, an active layer, and a second semiconductor layer of a second conductivity in a direction away from the first surface, such that the carrier blocking layer is configured to block a carrier moving from the second semiconductor layer toward the first semiconductor layer; each of the plurality of mesa structures being configured to generate colored light of a corresponding light emitting device in the active layer of the epitaxial structure farthest from the first surface, the active layer of the first epitaxial structure and the active layer of each of the at least one second epitaxial structure being configured to generate light of different wavelengths. The first surface may correspond to one surface of the first semiconductor layer of the first epitaxial structure. The plurality of light emitting devices may be formed in a monolithic shape connected through a partial thickness part of the first semiconductor layer of the first epitaxial structure.

A method of manufacturing a display apparatus may include: vertically stacking a plurality of epitaxial structures each having a sequentially stacked structure of a first semiconductor layer of a first conductivity, a carrier blocking layer, an active layer, and a second semiconductor layer of a second conductivity on a growth substrate to form a vertical stack of a first epitaxial structure of the plurality of epitaxial structures and at least one second epitaxial structure of the plurality of epitaxial structures, each of the active layers of the plurality of epitaxial structures having a different emission wavelength; etching to a part of the depth of the first semiconductor layer of the first epitaxial structure with respect to the vertical stack to form a plurality of mesa structures spaced apart from each other; removing at least one epitaxial structure from at least one mesa structure of the plurality of mesa structures so that at least two mesa structures of the plurality of mesa structures have different heights; and removing the growth substrate to expose a first surface of the first semiconductor layer of the first epitaxial structure. The display apparatus may be configured to emit light is through the first surface, and the plurality of mesa structures are spaced apart from each other on the second surface opposite to the first surface to form a plurality of light emitting devices that are each configured to emit light at different wavelengths. The plurality of light emitting devices may be formed in a monolithic shape connected through a partial thickness part of the first semiconductor layer of the first epitaxial structure. The carrier blocking may be configured to block a carrier moving from the second semiconductor layer toward the first semiconductor layer such that each of the plurality of mesa structures is configured to generate colored light of the corresponding light emitting device of the plurality of light emitting devices in the active layer of the epitaxial structure of the plurality of epitaxial structures farthest from the first surface.

The carrier blocking layer may include a hole blocking layer.

Each of the first epitaxial structure and the second epitaxial structure may further include an electron blocking layer between the active layer and the second semiconductor layer.

The method of manufacturing the display apparatus may further include forming a high-concentration doped junction layer to have the first conductivity on the second semiconductor layer of at least one epitaxial structure of the plurality of epitaxial structures to form a tunnel junction between epitaxial structures that are adjacent to each other in a vertical direction.

The method of manufacturing the display apparatus may further include forming a plurality of driving transistors for driving each of the plurality of light emitting devices by being electrically connected to each of the mesa structures before removing the growth substrate, to form the plurality of driving transistors and the plurality of light emitting devices in a monolithic manner.

The method of manufacturing the display apparatus may further include forming a common electrode patterned to form a plurality of opening regions through which light is configured to pass on the first surface of the first semiconductor layer of the first epitaxial structure exposed by removing the growth substrate.

The method of manufacturing the display apparatus of may further include forming a light extraction pattern in the opening region.

The method of manufacturing the display apparatus of may further include forming a first electrode in contact with the second semiconductor layer of the first epitaxial structure or the at least one of the second epitaxial structure that is farthest from the first surface of each of the plurality of mesa structures.

The first electrode may include a transparent electrode formed on a surface of the second semiconductor layer.

The width of each of the plurality of mesa structures may be in the range of 0.1 µm to 100 µm.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic conceptual diagram of a display apparatus according to an embodiment;
FIG. 2 is a schematic circuit diagram of a display apparatus according to an embodiment;
FIGS. 3 to 14 are cross-sectional views schematically illustrating a manufacturing process of a display apparatus according to an embodiment;
FIGS. 15 to 17 are cross-sectional views schematically illustrating a manufacturing process of a display apparatus according to other embodiments;
FIG. 18 is a schematic block diagram of an electronic apparatus according to an embodiment;
FIG. 19 illustrates an example in which a display apparatus according to an embodiment is applied to a mobile apparatus;
FIG. 20 illustrates an example in which a display apparatus according to an embodiment is applied to a display apparatus for a vehicle;
FIG. 21 illustrates an example in which a display apparatus according to an embodiment is applied to augmented reality glasses or virtual reality glasses;
FIG. 22 illustrates an example in which a display apparatus according to an embodiment is applied to a signage; and
FIG. 23 illustrates an example in which a display apparatus according to an embodiment is applied to a wearable display.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, example embodiments will be described in detail with reference to the accompanying drawings. In the following drawings, the same reference numerals refer to the same components, and the size of each component in the drawings may be exaggerated for clarity and convenience of description. Meanwhile, the embodiments described below are merely exemplary, and various modifications are possible from these embodiments.

Hereinafter, the term "upper portion" or "on" may also include "to be present above, below, or in the left or right on a non-contact basis" as well as "to be on the top portion, the bottom portion, or in the left or right in directly contact with". Singular expressions include plural expressions unless they are explicitly meant differently in context. In addition, when a part "includes" a component, this means that it may include more other components, rather than excluding other components, unless otherwise stated.

The use of the term "the" and similar indicative terms may correspond to both singular and plural. If there is no explicit description or contrary description of the steps constituting the method, these steps may be carried out in an appropriate order and are not necessarily limited to the stated order.

Further, the terms "unit", "module" or the like mean a unit that processes at least one function or operation, which may be implemented in hardware or software or implemented in a combination of hardware and software.

The connection or connection members of lines between the components shown in the drawings exemplarily represent functional connection and/or physical or circuit connections, and may be replaceable or represented as various additional functional connections, physical connections, or circuit connections in an actual apparatus.

The use of all examples or exemplary terms is simply for describing a technical idea in detail and the scope is not limited by these examples or exemplary terms unless limited by the claims.

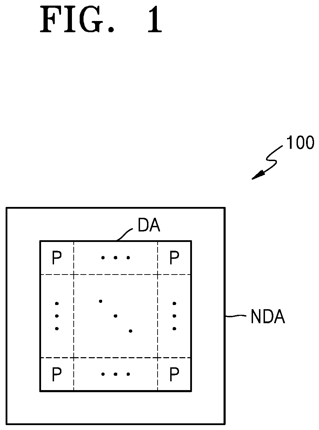

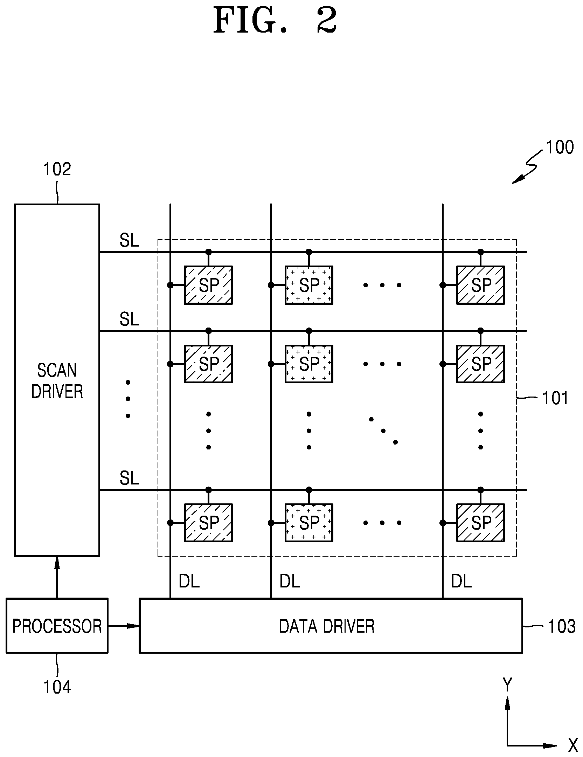

FIG. 1 is a schematic conceptual diagram of a display apparatus according to an embodiment, and FIG. 2 is a schematic circuit diagram of a display apparatus according to an embodiment. Referring to FIGS. 1 and 2, a display apparatus 100 may be divided into a display area DA and a non-display area NDA. The display area DA may be an area on which an image is displayed. The display area DA may include a plurality of pixels Ps for displaying an image. The plurality of pixels Ps may be arranged in the form of a two-dimensional array in the display area DA. Each of the plurality of pixels Ps may include a plurality of sub-pixels SPs of different colors.

The display apparatus 100 may include a pixel array 101, a scan driver 102, a data driver 103, and a processor 104. The pixel array 101 may be arranged in the display area DA of the display apparatus 100. The scan driver 102, the data driver 103, and the processor 104 may be arranged in the non-display area NDA of the display apparatus 100. FIG. 1 illustrates that the display area DA and the non-display area NDA are disposed in a plane, which is only an one possible example. For example, least some of the components of the non-display area NDA may be disposed at a position stacked within the display area DA.

The pixel array 101 may include a plurality of pixels Ps or a plurality of sub-pixels SPs, which are arranged in a two-dimensional array form, a plurality of scan lines SLs that transmit scan signals to the plurality of pixels Ps or the plurality of sub-pixels SPs, respectively, and a plurality of data lines DLs that transmit data signals to the plurality of pixels Ps or the plurality of sub-pixels SPs, respectively. Each of the plurality of scan lines SLs extends toward the scan driver 102 to receive a scan signal from the scan driver 102, and each of the plurality of data lines DLs extends toward the data driver 103 to receive a data signal from the data driver 103.

The plurality of scan lines SLs and the plurality of data lines DLs may extend, for example, in a direction crossing each other. Although FIG. 2 illustrates that the plurality of scan lines SLs extend in the X direction and the plurality of data lines DLs extend in the Y direction, the embodiments are not necessarily limited thereto, and the extension directions of the plurality of data lines DLs and the plurality of scan lines SLs may be interchanged. For example, sub-pixels SPs may be respectively disposed at positions where the plurality of scan lines SLs intersect with the plurality of data lines DLs. As another example, the extension directions of the plurality of data lines DLs and the plurality of scan lines SLs may be parallel to each other, and each of the sub-pixels SPs may be electrically connected to each of the scan line SLs and each of the data line DLs.

Each of the plurality of sub-pixels SPs may include a light emitting device and a driving circuit such as a driving transistor for driving the light emitting device. The light emitting device may be a micro-light emitting device having a micro-scale size. For example, the light emitting device may have a size in the range of about 0.1 µm to about 100 µm. According to an embodiment, each pixel P may include a plurality of sub-pixels SPs displaying different colors, the light emitting devices of the plurality of sub-pixels SPs may be formed in a vertical stacked epitaxial structure on one growth substrate, and the display apparatus 100 may include a monolithic color light emitting structure. According to an embodiment, the light emitting devices and the driving transistors may be formed together on one growth substrate or may be formed on different growth substrates.

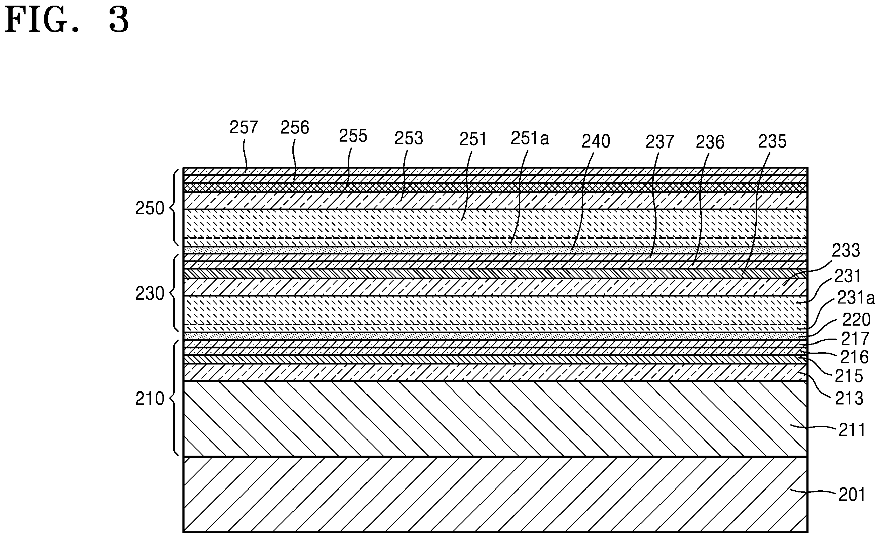

FIGS. 3 to 14 are cross-sectional views schematically illustrating a manufacturing process of a display apparatus according to an embodiment. Here, a process in which the light emitting devices and the driving transistors are formed together on one growth substrate 201 is illustrated as an example.

First, referring to FIG. 3, in order to manufacture a display apparatus according to an embodiment, a light emitting structure in which a plurality of epitaxial structures for generating light of different wavelengths, for example, a first epitaxial structure 210, a second epitaxial structure 230, and a third epitaxial structure 250 are sequentially vertically stacked may be formed on the growth substrate 201.

That is, the plurality of epitaxial structures for emission of each color light may be sequentially stacked on the growth substrate 201. For example, the first epitaxial structure 210 for emission of first color light, the second epitaxial structure 230 for emission of second color light on the first epitaxial structure 210, and the third epitaxial structure 250 for emission of third color light on the second epitaxial structure 230 may be sequentially stacked on the growth substrate 201 to form a vertically stacked epitaxial structure. Here, for example, the first color light, the second color light, and the third color light may respectively be red light, green light, and blue light. In some embodiments, a color implementation of a display apparatus may be performed through first to third color light emission, but the embodiments are not limited thereto. The number of epitaxial structures stacked may vary depending on the number of color light for color implementation. Hereinafter, a process of manufacturing a display apparatus that implements a color display through first to third color light emission will be described as an example.

The growth substrate 201 may include, for example, silicon, sapphire, or GaAs. The growth substrate 201 may include a material other than the materials described above.

A buffer layer (not shown) may be provided between the growth substrate 201 and the first epitaxial structure 210 to relieve stress due to a lattice constant difference between the growth substrate 201 and a first semiconductor layer 211 of the first epitaxial structure 210. The buffer layer may be grown to have crystallinity using, for example, a chemical vapor deposition (CVD) process, a physical vapor deposition (PVD) process, or an atomic layer deposition (ALD) process. The lattice constant of the buffer layer may have a value between the lattice constant of the growth substrate 201 and the lattice constant of the first semiconductor layer 211, or may have the same value as the lattice constant of the first semiconductor layer 211. The buffer layer may include, for example, a group III-V compound semiconductor, such as GaN, GaP, or GaAs. In addition, the buffer layer may be doped with the same conductive type as the first semiconductor layer 211. For example, when the first semiconductor layer 211 is doped n-type, the buffer layer may include n-GaN, n-GaP, or n-GaAs, and when the first semiconductor layer 211 is doped p-type, the buffer layer may include p-GaN, p-GaP, or p-GaAs.

The first to third epitaxial structures 210, 230, and 250 may have sequential stacked structures of first conductive type first semiconductor layers 211, 231, and 251 of a first conductive type, first carrier blocking layers 213, 233, and 253, active layers 215, 235, and 255, and second conductive type second semiconductor layers 217, 237, and 257, respectively. The first to third epitaxial structures 210, 230, and 250 may further include second carrier blocking layers 216, 236, and 256 between the active layers 215, 235, and 255 and the second semiconductor layers 217, 237, and 257, respectively.

In order to form the first epitaxial structure 210, the first semiconductor layer 211 is formed on the growth substrate 201 (a buffer layer in the case that the buffer layer is provided), the first carrier blocking layer 213 is formed on the first semiconductor layer 211, the active layer 215 for emitting first color light is formed on the first carrier blocking layer 213, the second carrier blocking layer 216 is formed on the active layer 215, and the second semiconductor layer 217 is formed on the second carrier blocking layer 216.

In order to form the second epitaxial structure 230, the first semiconductor layer 231 is formed on the second semiconductor layer 217 of the first epitaxial structure 210, the first carrier blocking layer 233 is formed on the first semiconductor layer 231, the active layer 235 for emitting second color light is formed on the first carrier blocking layer 233, the second carrier blocking layer 236 is formed on the active layer 235, and the second semiconductor layer 237 is formed on the second carrier blocking layer 236.

In order to form the third epitaxial structure 250, the first semiconductor layer 251 is formed on the second semiconductor layer 237 of the second epitaxial structure 230, the first carrier blocking layer 253 is formed on the first semiconductor layer 251, the active layer 255 for emitting third color light is formed on the first carrier blocking layer 253, the second carrier blocking layer 256 is formed on the active layer 255, and the second semiconductor layer 257 is formed on the second carrier blocking layer 256.

As described above, the first to third epitaxial structures 210, 230, and 250 include the first carrier blocking layers 213, 233, and 253 to block carriers (holes or electrons) moving in the directions from the second semiconductor layers 217, 237, and 257 to the first semiconductor layers 211, 231, and 251. The first to third epitaxial structures 210, 230, and 250 may further include the second carrier blocking layers 216, 236, and 256 to block carriers (holes or electrons) moving in the directions from the first semiconductor layers 211, 231, and 251 to the second semiconductor layers 217, 237, and 257. The first to third epitaxial structures 210, 230, and 250 may not include the second carrier blocking layers 216, 236, and 256. In the present embodiment, the case in which the first to third epitaxial structures 210, 230, and 250 include all of the first carrier blocking layers 213, 233, and 253 and the second carrier blocking layer 216, 236, and 256 will be described as an example, but the embodiments are not limited thereto.

The first semiconductor layers 211, 231, and 251 may be doped with a first conductive type, and the second semiconductor layers 217, 237, and 257 may be doped with a second conductive type electrically opposite to the first conductive type. For example, the first semiconductor layers 211 and 231, and 251 may be doped n-type and the second semiconductor layers 217, 237, and 257 may be doped p-type, or the first semiconductor layers 211 and 231, and 251 may be doped p-type, and the second semiconductor layers 217, 237, and 257 may be doped n-type. Either the first semiconductor layers 211, 231, and 251 or the second semiconductor layers 217, 237, and 257 may be group III-V compound semiconductor layers doped n-type, and the others may be group III-V compound semiconductor layers doped p-type.

Either the first carrier blocking layers 213, 233, and 253 or the second carrier blocking layers 216, 236, and 256 may be hole blocking layers (HBLs), and the others may be electron blocking layers (EBLs). For example, when the first semiconductor layers 211 and 231, and 251 are doped n-type and the second semiconductor layers 217, 237, and 257 are doped p-type, the first carrier blocking layers 213 and 233, and 253 may be an HBL, and the second carrier blocking layers 216 and 236, and 256 may be an EBL. As another example, when the first semiconductor layers 211 and 231, and 251 are doped p-type and the second semiconductor layers 217, 237, and 257 are doped n-type, the first carrier blocking layers 213 and 233, and 253 may be EBLs, and the second carrier blocking layers 216 and 236, and 256 may be HBLs.

For example, in the light emitting structure and the display apparatus, the first carrier blocking layers 213, 233, and 253 may include HBLs, and in each of the first to third epitaxial structures 210, 230, and 250, the EBLs may be further included as the second carrier blocking layers 216, 236, and 256 between the active layers 215, 235, and 255 and the second semiconductor layers 217, 237, and 257, respectively.

The active layers 215, 235, and 255 generate light by recombining electrons and holes, which are respectively provided from the first semiconductor layers 211, 231, and 251 and the second semiconductor layers 217, 237, and 257. To this end, the active layers 215, 235, and 255 may have a quantum well structure in which a quantum well is located between barriers. The wavelength of light generated in the active layers 215, 235, and 255 may be determined according to the energy bandgap of the material constituting the quantum wells in the active layers 215, 235, and 255. The active layers 215, 235, and 255 may have only one quantum well, but may also have a multi-quantum well (MQW) structure in which a plurality of quantum wells are arranged. The energy of the quantum well in the conduction band, may be selected to be lower than the energy of the barrier. To this end, the barriers and quantum wells in the active layers 215, 235, and 255 may include different compound semiconductors or compound semiconductors having different compositions.

In some embodiments, the first semiconductor layers 211, 231, and 251, the active layers 215, 235, and 255, the second semiconductor layers 217, 237, and 257, the first carrier blocking layers 213, 233, and 253, and the second carrier blocking layers 216, 236, and 256 may include, for example, a group III-V compound semiconductor based on GaN. For example, the first semiconductor layers 211 and 231, and 251, the active layers 215, 235, and 255, and the second semiconductor layers 217, 237, and 257 may include group III-V compound semiconductors, such as GaN, InGaN, AlInGaN, and AlGaInP, and the first semiconductor layers 211, 231, and 251 and the second semiconductor layers 217, 237, and 257 may be doped with conductive types (e.g., first conductivity and second conductivity being electrically opposite to each other) opposite to each other. For example, either the first carrier blocking layers 213, 233, and 253 or the second carrier blocking layers 216, 236, and 256 may include AlGaN and the others may include AlInGaN.

For example, the first semiconductor layers 211, 231, and 251 and the second semiconductor layers 217, 237, and 257 may include GaN and may be doped with opposite conductivity types. That is, the first semiconductor layers 211 and 231, and 251 may include a GaN layer doped n-type, and the second semiconductor layers 217, 237, and 257 may include a GaN layer doped p-type. As an example, the first semiconductor layers 211 and 231, and 251 may include a GaN layer doped p-type, and the second semiconductor layers 217, 237, and 257 may include a GaN layer doped n-type. The active layers 215, 235, and 255 may include, for example, InGaN, and may have different composition ratios of In and Ga according to a desired emission wavelength.

In each of the first epitaxial structure 210, the second epitaxial structure 230, and the third epitaxial structure 250, the active layers 215, 235, and 255 may have, for example, a stacked structure of a first barrier-a quantum well-a second barrier. The first barrier may be, for example, a GaN barrier, which may or may not be doped with Si. The quantum well may have a single quantum well structure or a multi-quantum well structure. For example, the quantum well may include a single stacked structure or a plurality of stacked structures of InGaN/GaN or InGaN/GaN/AlGaN. In InₓGa₁₋ₓN of the stacked structure forming a quantum well, the composition ratio of In and Ga may vary depending on the emission wavelength. The GaN of the stacked structure forming the quantum well may or may not be doped with Si.

For example, when blue light, green light, and red light are generated in the first epitaxial structure 210, the second epitaxial structure 230, and the third epitaxial structure 250, respectively, the active layer 235 of the second epitaxial structure 230 and the active layer 255 of the third epitaxial structure 250 may or may not include an AlGaN layer, and the active layer 215 of the first epitaxial structure 210 may not include an AlGaN. That is, in the active layer 235 of the second epitaxial structure 230 and the active layer 255 of the third epitaxial structure 250, the quantum well may include a single stack structure or a plurality of stacked structures of InₓGa₁₋ₓN/GaN or InₓGa₁₋ₓN/GaN/AlGaN, and in the active layer 215 of the first epitaxial structure 210, the quantum well may include a single stacked structure or a plurality of stacked structures of InₓGa₁₋ₓN/GaN.

When the first epitaxial structure 210 generates blue light, x in InₓGa₁₋ₓN constituting the active layer 215 may be, for example, about 0.16 to 0.17. When the second epitaxial structure 230 generates green light, x in InₓGa₁₋ₓN constituting the active layer 235 may be, for example, about 0.23 to 0.24. When the third epitaxial structure 250 generates red light, x in InₓGa₁₋ₓN constituting the active layer 255 may be, for example, about 0.34 to 0.35. Here, it has been described that the first epitaxial structure 210, the second epitaxial structure 230, and the third epitaxial structure 250 generate blue light, green light, and red light, respectively, but the embodiments are not limited thereto. For example, the first epitaxial structure 210 may be provided to generate red light or green light, the second epitaxial structure 230 may be provided to generate blue light or red light, and the third epitaxial structure 250 may be provided to generate green light or blue light. In addition, the first to third epitaxial structures 210, 230, and 250 may be provided to generate a combination of color light of other wavelength bands, for example, yellow, magenta, and cyan color light, rather than blue light, green light, and red light. Hereinafter, for convenience, it will be described as an example that the first epitaxial structure 210 generates the blue light, the second epitaxial structure 230 generates the green light, and the third epitaxial structure 250 generates the red light.

In the first to third epitaxial structures 210, 230, and 250, either the first carrier blocking layers 213, 233, and 253 or the second carrier blocking layers 216, 236, and 256 are EBLs, and the others are HBLs. For example, the EBL may include p-type AlGaN, the HBL may include AlInGaN, and the composition ratio of Al in the HBL may be 0.2 or less.

In the light emitting structure and the display apparatus according to the embodiment, a tunnel junction may be further formed between adjacent epitaxial structures. To this end, a junction layer highly doped with the same conductivity type as the first semiconductor layer of another epitaxial structure adjacent thereto may be further formed on the second semiconductor layer of one epitaxial structure.

For example, tunnel junctions may be further formed between the second semiconductor layer 217 of the first epitaxial structure 210 and the first semiconductor layer 231 of the second epitaxial structure 230, and between the second semiconductor layer 237 of the second epitaxial structure 230 and the first semiconductor layer 251 of the third epitaxial structure 250, respectively. To this end, first and second junction layers 220 and 240 highly doped with the same conductivity type as the first semiconductor layers 231 and 254 may be further formed between the second semiconductor layer 217 of the first epitaxial structure 210 and the first semiconductor layer 231 of the second epitaxial structure 230, and between the second semiconductor layer 237 of the second epitaxial structure 230 and the first semiconductor layer 251 of the third epitaxial structure 250, respectively. Each of the first junction layer 220 and the second junction layer 240 may be provided to form a tunnel junction within a range of, for example, about 10 nm or less. Here, an example in which both the first junction layer 220 and the second junction layer 240 are provided are described, but the embodiments are not limited thereto. For example, a tunnel junction may be further formed only either between the second semiconductor layer 217 of the first epitaxial structure 210 and the first semiconductor layer 231 of the second epitaxial structure 230, or between the second semiconductor layer 237 of the second epitaxial structure 230 and the first semiconductor layer 251 of the third epitaxial structure 250.

Like the first to third epitaxial structures 210, 230, and 250, each of the first junction layer 220 and the second junction layer 240 may include, for example, a group III-V compound semiconductor based on GaN. For example, the first junction layer 220 and the second junction layer 240 may include a Group III-V compound semiconductor, such as GaN, InGaN, AlInGaN, or AlGaInP. For example, the first junction layer 220 and the second junction layer 240 may include GaN. In addition, the first junction layer 220 may form a tunnel junction with the second semiconductor layer 217 of the first epitaxial structure 210, and may be doped with a higher doping concentration than the first semiconductor layer 231 in the same conductive type as that of the first semiconductor layer 231 of the second epitaxial structure 230. In addition, the second junction layer 240 may form a tunnel junction with the second semiconductor layer 237 of the second epitaxial structure 230, and may be doped with a higher doping concentration than the first semiconductor layer 251 in the same conductive type as that of the first semiconductor layer 251 of the third epitaxial structure 250.

For example, when the first semiconductor layers 231 and 251 of the second epitaxial structure 230 and the third epitaxial structure 250 are doped n-type, each of the first junction layer 220 and the second junction layer 240 may be doped n++ type. The n++ type doping may be obtained by, for example, a Si doping concentration of 10¹⁹ or more. In this case, some thickness portions 231a and 251a of the first semiconductor layers 231 and 251, which are adjacent to the first and second junction layers 220 and 240, respectively, may have a greater doping concentration than the remaining thickness portions of the of the first semiconductor layers 231 and 251. When the first semiconductor layers 231 and 251 are doped n-type, the adjacent thickness portions 231a and 251a of the first semiconductor layers 231 and 251 may be formed n+ type, and the remaining thickness portions of the first semiconductor layers 231 and 251 may be formed n-type. For example, the first junction layer 220 and the second junction layer 240 may be formed of n++ type GaN, the adjacent thickness portions 231a and 251a of the first semiconductor layers 231 and 251 may be formed of n+ type GaN, and the remaining thickness portions of the first semiconductor layers 231 and 251 may be formed of n-GaN. As another example, when the first semiconductor layers 231 and 251 are doped p-type, the first and second junction layers 220 and 240 may be doped p++ type. In this case, some thickness portions 231a and 251a of the first semiconductor layers 231 and 251, which are adjacent to the first and second junction layers 220 and 240, respectively, may have a greater doping concentration than the remaining thickness portions. When the first semiconductor layers 231 and 251 are doped p type, adjacent thickness portions 231a and 251a of the first semiconductor layers 231 and 251 may be formed of a p+ type, and the remaining thickness portions of the first semiconductor layers 231 and 251 may be formed of a p type.

When the doping concentrations of the first and second junction layers 220 and 240, adjacent thickness portions 231a and 251a of the first semiconductor layers 231 and 251, and the remaining thickness portions of the first semiconductor layers 231 and 251 are respectively a first doping concentration, a second doping concentration, and a third doping concentration, the first and second junction layers 220 and 240 and the first semiconductor layers 231 and 251 may be formed to satisfy the relationship of the first doping concentration being greater than the second doping concentration which is greater than the third doping concentration.

In some embodiments, for example, in the first to third epitaxial structures 210, 230, and 250, the first semiconductor layers 211, 231, and 251 may be formed of n-GaN, the first carrier blocking layers 213, 233, and 253 may be formed of AlInGaN as an HBL, the second carrier blocking layers 216, 236, and 256 may be formed of p-AlGaN as an EBL, the second semiconductor layers 217, 237, and 257 may be formed of p-GaN, and the first junction layer 220 and the second junction layer 240 may be formed of n++ GaN. In the first to third epitaxial structures 210, 230, and 250, the active layers 215, 235, and 255 may have a stacked structure of (i) a first barrier (ii) a single or a multiple quantum well, and (iii)a second barrier. The first barrier may be formed of GaN, and may be doped or undoped with Si. The second barrier may be formed of GaN, for example, Intrinsic GaN. The quantum well may include a single stacked structure or a plurality of stacked structures of InGaN/GaN or InGaN/GaN/AlGaN, the composition ratio of In and Ga in InₓGa₁₋ₓN may vary depending on emission wavelength, and GaN may be doped or undoped with Si. When blue light, green light, and red light are generated in the first epitaxial structure 210, the second epitaxial structure 230, and the third epitaxial structure 250, respectively, the active layer 235 of the second epitaxial structure 230 and the active layer 255 of the third epitaxial structure 250 may or may not include an AlGaN layer, and the active layer 215 of the first epitaxial structure 210 may not include an AlGaN. In the first epitaxial structure 210, the second epitaxial structure 230, and the third epitaxial structure 250, the x value in InₓGa₁₋ₓN of the active layers 215, 235, and 255 may vary depending on the emission wavelength, as described above.

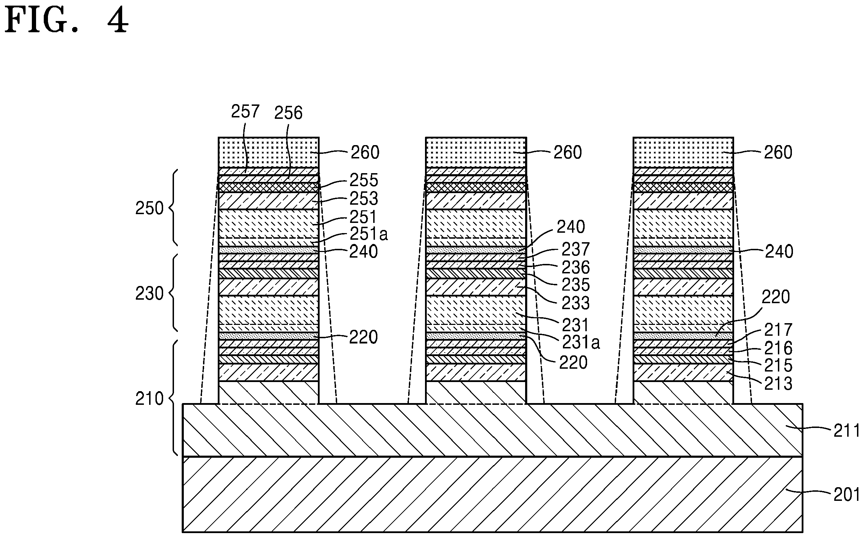

As shown in FIG. 3, the first epitaxial structure 210, the second epitaxial structure 230, and the third epitaxial structure 250 are sequentially stacked on the growth substrate 201, and then, as shown in FIGS. 4 to 6, an etching process may be performed to form an array of a plurality of mesa structures, and a selective etching process may be performed so that at least two mesa structures of the plurality of mesa structures have different heights, thereby forming first to third mesa structures 310, 330, and 350 having different heights. The first to third mesa structures 310, 330, and 350 may correspond to first to third light emitting devices, respectively.

Referring to FIG. 4, a mask pattern 260 is formed on a sequential vertical stack of the first to third epitaxial structures 210, 230, and 250 and regions excluding light emitting regions are etched to a partial depth of the first semiconductor layer 211 of the first epitaxial structure 210 to form an array of a plurality of mesa structures.

The mask pattern 260 for forming a plurality of mesa structures may be formed of, for example, a SiO₂ hard mask. Regions not covered by the mask pattern 260 may be etched to a partial depth of the first semiconductor layer 211 of the first epitaxial structure 210 through a dry etching process to form a plurality of mesa structures. In this case, since the mesa structures formed by the dry etching process may have inclined sidewalls (represented by a dashed line in FIG. 4), a wet etching process may be additionally performed to increase the inclinations of the inclined sidewalls of the mesa structures 310, 330, and 350. By increasing the inclination of the inclined sidewall of the mesa structure through a wet etching process, the mesa structure may be made relatively constant in width. In FIG. 4, the dashed line profiles represent the mesa structures formed by a dry etching process. The dry etching process may use, for example, inductively coupled plasma (ICP). The wet etching process may be performed using, for example, a potassium hydroxide (KOH) solution or a tetramethyl ammonium hydroxide (TMAH) solution as an etchant. The widths of the mesa structures thus formed may be relatively constant. The width of each of the mesa structures may be in the range of, for example, about 0.1 µm to about 100 µm. Accordingly, as will be described later, the light emitting device formed to correspond to the mesa structure may form a micro light emitting device.

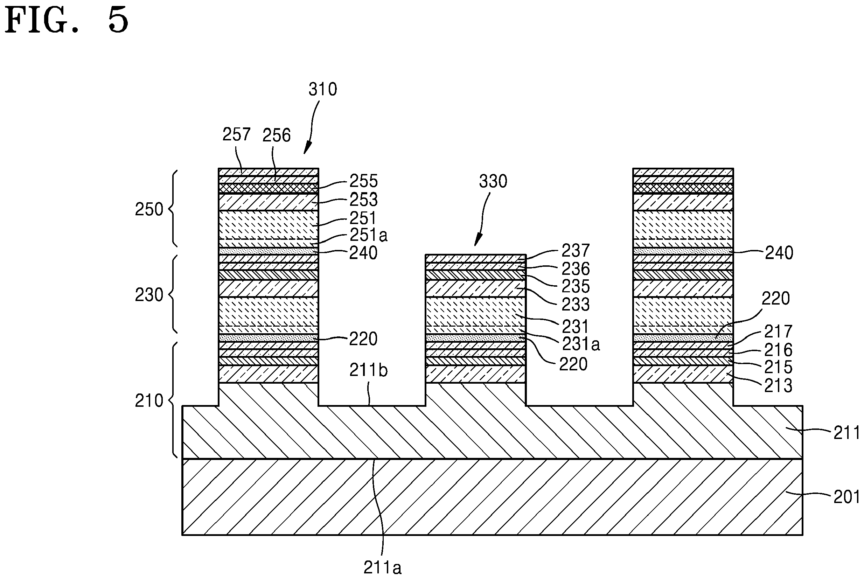

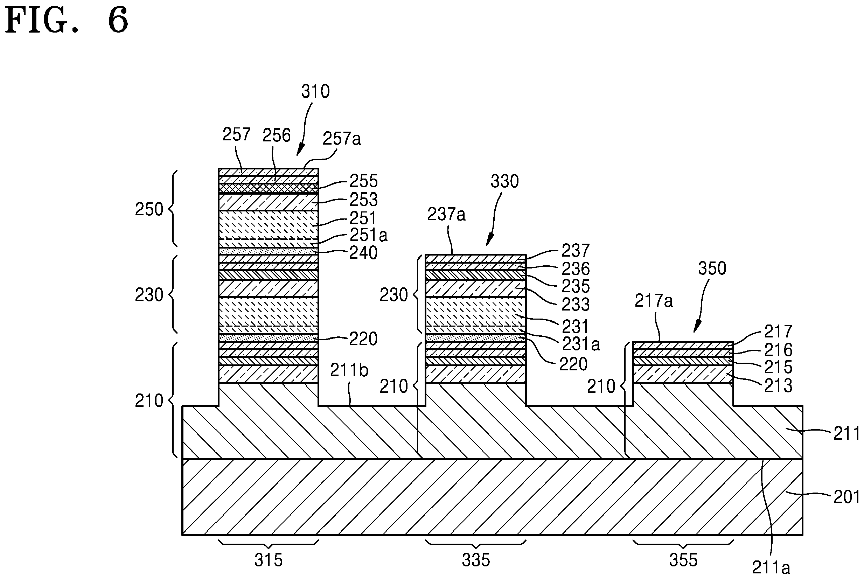

Referring to FIGS. 5 and 6, at least one epitaxial structure may be removed with respect to at least one mesa structure to form at least two mesa structures of the plurality of mesa structures to have different heights. The first to third mesa structures 310, 330, and 350 having different heights may be formed by the selective etching process of the mesa structure, and each of the first to third mesh structures 310, 330, and 350 may have a width within a range of, for example, about 0.1 µm to about 100 µm. In FIGS. 5 and 6, reference numeral 211a denotes a first surface at which the first semiconductor layer 211 of the first epitaxial structure 210 starts to grow with respect to the growth substrate 201. As will be described later, since the growth substrate 201 is removed, the first surface 211a is a surface from which light of different wavelengths emitted from the first to third light emitting devices 315, 335, and 355 formed by the first to third mesa structures 310, 330, and 350 is emitted, and a second surface opposite to the first surface 211a corresponds to an exposed surface 211b, and the first to third mesa structures 310, 330, and 350 are formed to be spaced apart from each other on the second surface.

For example, referring to FIG. 5, the etching process may not be performed on the first mesa structure 310, and an etching process is performed to remove even the third epitaxial structure 250 positioned at the uppermost end and the second junction layer 240 to form the second mesa structure 330. Referring to FIG. 6, in order to form the third mesa structure 350, an etching process is performed to remove even the third epitaxial structure 250, the second junction layer 240, the second epitaxial structure 230, and the first junction layer 220. The order of the etching process for forming the second mesa structure 330 and the etching process for forming the third mesa structure 350 may be changed.

As described above, when the first to third mesa structures 310, 330, and 350 are formed by the selective etching process, the following structures may be obtained. That is, the first mesa structure 310 includes the third epitaxial structure 250 on which the second semiconductor layer 257 is exposed. The second mesa structure 330 includes the second epitaxial structure 230 on which the second semiconductor layer 237 is exposed. The third mesa structure 350 includes a first epitaxial structure 210 in which the second semiconductor layer 217 is exposed. The exposed surface 211b of which the thickness of the first semiconductor layer 211 of the first epitaxial structure 210 is etched is positioned in each region of between the first to third mesa structures 310, 330, and 350.

The height of the first to third mesa structures 310, 330, and 350 formed by the selective etching process may correspond to, for example, a thickness from the exposed surface 211b which is obtained by etching a partial thickness of the first semiconductor layer 211 of the first epitaxial structure 210 to the upper surface of the second semiconductor layer of the epitaxial structure positioned at the top of each mesa structure.

For example, the first mesa structure 310 may have a height from the etched exposed surface 211b of the first semiconductor layer 211 of the first epitaxial structure 210 to the top surface 257a of the second semiconductor layer 257 of the third epitaxial structure 250, the second mesa structure 330 may have a height from the etched exposed surface 211b of the first semiconductor layer 211 to the top surface 237a of the second semiconductor layer 237 of the second epitaxial structure 230, and the third mesa structure 350 may have a height from the etched exposed surface 211b of the first semiconductor layer 211 to the top surface 217a of the second semiconductor layer 217 of the first epitaxial structure 210.

As described above, the first to third mesa structures 310, 330, and 350 having different heights may be formed by the selective etching process for the plurality of mesa structures, and thus the first mesa structure 310 may form first light emitting device 315 that emits light of wavelength corresponding to the active layer 255 of the third epitaxial structure 250 positioned at the uppermost, the second mesa structure 330 may form second light emitting device 335 that emits light of wavelength corresponding to the active layer 235 of the second epitaxial structure 230 positioned at the uppermost, and the third mesa structure 350 may form third light emitting device 355 that emits light of wavelength corresponding to the active layer 215 of the first epitaxial structure 210 positioned at the uppermost.

That is, in the first mesa structure 310, carriers, such as holes, are blocked by the first carrier blocking layer 253 in the direction from the second semiconductor layer 257 of the third epitaxial structure 250 to the first semiconductor layer 251, and thus, carriers, for example, holes are not transferred from the third epitaxial structure to the first epitaxial structure 210 and the second epitaxial structure 230 located below. Accordingly, the first mesa structure 310 may form a first color light emitting region, for example, a red light emitting region, by the third epitaxial structure 250, thereby forming the first light emitting device 315 emitting the first color light.

In the second mesa structure 330, carriers, such as holes, may be blocked by the first carrier blocking layer 233 in the direction from the second semiconductor layer 237 of the second epitaxial structure 230 to the first semiconductor layer 231, and thus, carriers, for example, holes are not transferred from the second epitaxial structure 230 to the first epitaxial structure 210 located below. Accordingly, the second mesa structure 330 may form a second color light emitting region, for example, a green light emitting region, by the second epitaxial structure 230, thereby forming the second light emitting device 335 emitting the second color light.

The third mesa structure 350 forms a third color light emitting region, for example, a blue light emitting region, by the first epitaxial structure 210, thereby forming a third light emitting device 355 emitting the third color light.

In this way, the first to third light emitting devices 315, 335, and 355 that emit light of different wavelengths may be formed. That is, the first to third light emitting devices 315, 335, and 355 emitting the first to third light colors may be formed.

In addition, since the first to third colored light emitting regions formed by the first to third mesh structures 310, 330, and 350 may be spaced apart from each other, the first to third light emitting devices 315, 335, and 355 may be spaced apart from each other but are connected through a part of the thickness of the first semiconductor layer 211 of the first epitaxial structure 210, thereby being formed in a monolithic shape.

In addition, as described above, by forming the width of each of the first to third mesh structures 310, 330, and 350 within a range of about 0.1 µm to about 100 µm, the first to third light emitting devices 315 to 335, and 355 may be formed of first to third micro light emitting devices, respectively. That is, since the first to third micro light emitting devices are connected through a part of the thickness of the first semiconductor layer 211 of the first epitaxial structure 210, the first to third micro light emitting devices may be formed in a monolithic form.

In view of the entire growth substrate 201, since the first to third mesa structures 310, 330, and 350 are two-dimensionally and repeatedly arranged, the first to third light emitting devices 315, 335, and 355, for example, the first to third micro light emitting devices, may be two-dimensionally and repeatedly arranged in a monolithic form, thereby implementing a monolithic micro light emitting device display apparatus.

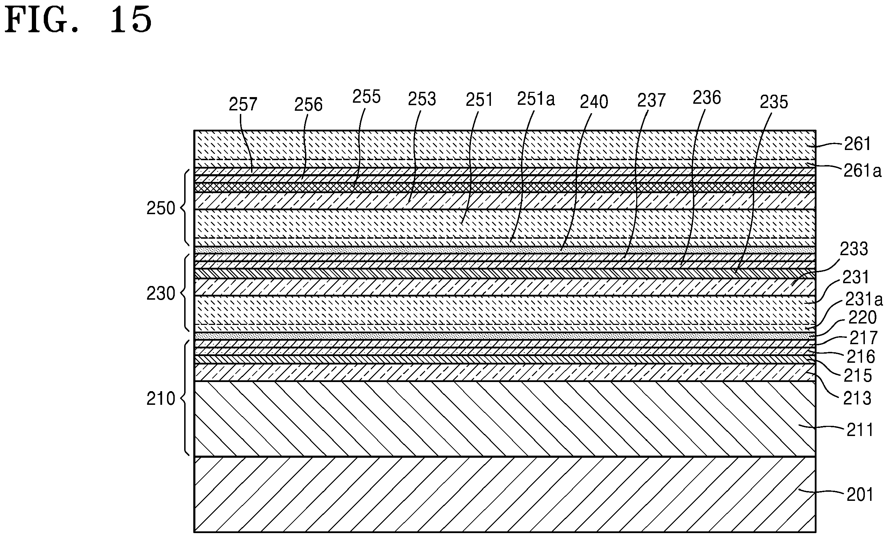

FIGS. 3 to 6 show an example in which the first to third mesa structures 310, 330, and 350 formed by the selective etching process are formed to expose the second semiconductor layer 257 of the third epitaxial structure 250, the second semiconductor layer 237 of the second epitaxial structure 230, and the second semiconductor layer 217 of the first epitaxial structure 210 on the uppermost surfaces thereof, respectively, but the embodiments are not limited thereto. For example, layers for preventing damage to the second semiconductor layers 257, 237, and 217 may exist on the uppermost surfaces of the first to third mesa structures 310, 330, and 350, respectively. To this end, the vertical stack epitaxial structure for forming the first to third mesa structures 310, 330, and 350 may further include a first semiconductor layer 261 on the second semiconductor layer 257 of the third epitaxial structure 250, as shown as an example in FIG. 15. In addition, a junction layer (not shown) may be further provided between the semiconductor layer 261 and the second semiconductor layer 257 of the third epitaxial structure 250.

Referring to FIG. 15, in the vertical stack epitaxial structure, the first semiconductor layer 261 may be stacked on the second semiconductor layer 257 of the third epitaxial structure 250, and may include a group III-V compound semiconductor based on GaN doped with an opposite type to that of the second semiconductor layer 257. For example, the first semiconductor layer 261 may include a group III-V compound semiconductor, such as GaN, InGaN, AlInGaN, or AlGaInP, and may be doped with a first conductive type opposite to that of the second semiconductor layer 257. The thickness portion 261a of the first semiconductor layer 261 adjacent to the second semiconductor layer 257 of the third epitaxial structure 250 may have a greater doping concentration than the remaining thickness portions. For example, when the second semiconductor layer 257 of the third epitaxial structure 250 is doped p type, a thickness portion 251a of the first semiconductor layer 261 close to the second semiconductor layer 257 may be formed of an n+ type, and the remaining thickness portion of the first semiconductor layer 261 may be formed of an n type. For example, the thickness portion 261a of the first semiconductor layer 261 close to the second semiconductor layer 257 may be formed of n+ GaN, and the remaining thickness portion may be formed of n GaN. As another example, a junction layer (not shown) may be further provided between the first semiconductor layer 261 and the second semiconductor layer 257 of the third epitaxial structure 250, and in this case, the junction layer may be doped n++ type when the first semiconductor layer 251 of the third epitaxial structure 250 is doped n type, like the first junction layer 220 and the second junction layer 240 described above. For example, the junction layer may be formed of n++ GaN.

As described above and as shown in FIG. 15, the vertical stack epitaxial structure may be formed to further include the first semiconductor layer 261 on the second semiconductor layer 257 of the third epitaxial structure 250, and thus, a monolithic color light emitting structure, which includes a layer for preventing damage to each of the second semiconductor layers 257, 237, and 217, may be formed on the uppermost surface of each of the first to third mesa structures 310, 330, and 350.

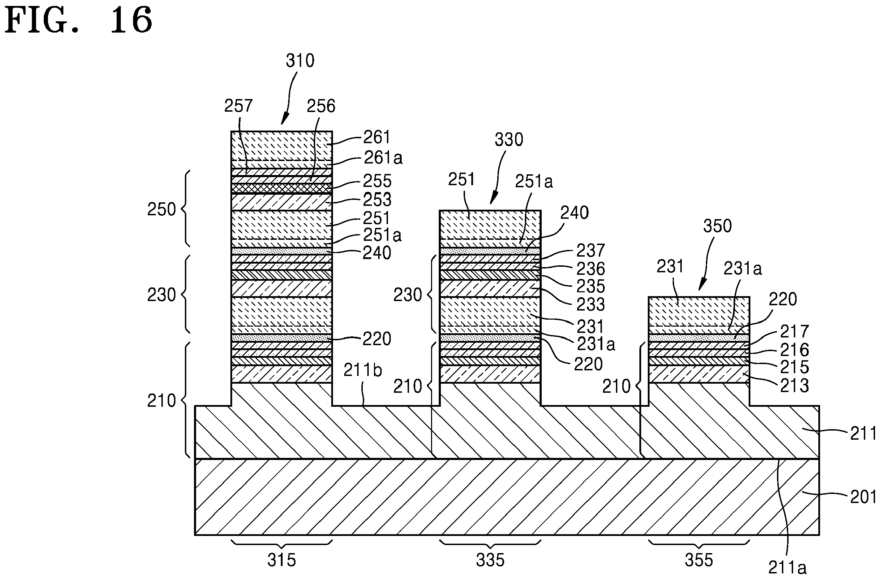

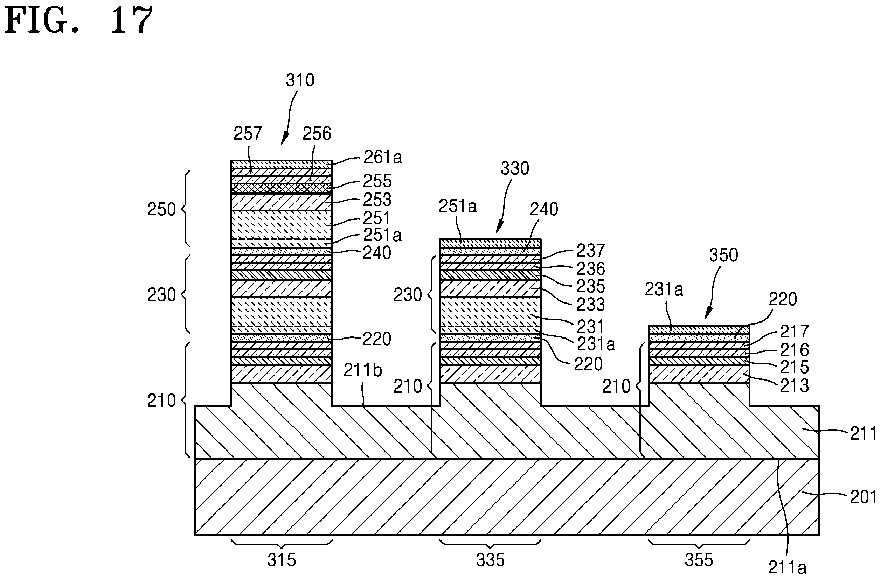

That is, as described with reference to FIG. 4, a plurality of mesa structure arrangements may be formed by an etching process using the mask pattern 260, and the first to third mesa structures 310, 330, and 350 having different heights, as shown in FIGS. 16 and 17, may be formed by the selective etching process described with reference to FIGS. 5 and 6.

Referring to FIG. 16, the first mesa structure 310 may include the first semiconductor layer 261 for protecting the second semiconductor layer 257 of the third epitaxial structure 250 at the uppermost end thereof, and correspondingly, a selective etching process may be performed to include the first semiconductor layers 251 and 231 at the uppermost ends of the second mesa structure 330 and the third mesa structure 350. When the vertical stack epitaxial structure includes the second junction layer 240, the second junction layer 240 and the first junction layer 220 may also be left at the uppermost ends of the second mesh structure 330 and the third mesh structure 350 together with both of the first semiconductor layers 251 and 231.

In addition, referring to FIG. 17, in order to protect the second semiconductor layer 257 of the third epitaxial structure 250 at the uppermost end thereof, the first mesa structure 310 may be formed such that at least a part of the thickness portion 261a of the first semiconductor layer 261 is left, and correspondingly, a selective etching process may be performed to leave some thickness portions 251a and 231a of the first semiconductor layers 251 and 231 at the uppermost ends of the second mesa structure 330 and the third mesa structure 350. When the vertical stack epitaxial structure includes the second junction layer 240, the second junction layer 240 and the first junction layer 220 may also be left at the uppermost ends of the second mesa structure 330 and the third mesa structure 350 together with some thicknesses 251a and 231a of the first semiconductor layers 251 and 231.

In this way, the first to third mesa structures 310, 330, and 350 formed by the selective etching process may have a structure exposing the second semiconductor layer 257of the third epitaxial structure 250, the second semiconductor layer 237 of the second epitaxial structure 230, and the second semiconductor layer 217 of the first epitaxial structure 210, respectively, on the uppermost surfaces thereof, or may have a layer on each of the uppermost surfaces thereof to prevent damage to each of the second semiconductor layers 257, 237, and 217.

In the drawings described below, an example of manufacturing a display apparatus with respect to the first to third mesh structures 310, 330, and 350 of FIG. 6 exposing the second semiconductor layers 257, 237, and 217 at the uppermost surfaces thereof is illustrated, but the embodiments are not limited thereto. That is, as described with reference to FIGS. 15 to 17, a process described below is applied to the first to third mesa structures 310, 330, and 350 in which a layer for preventing damage to each of the second semiconductor layers 257, 237, and 217 is present on the uppermost surface thereof, to thereby manufacture a display apparatus.

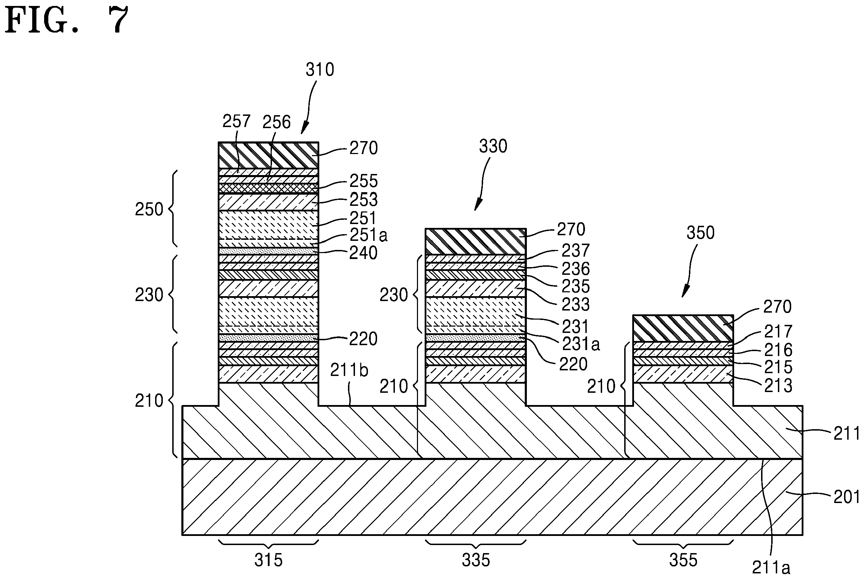

As shown in FIG. 6, when the second semiconductor layers 257, 237, and 217 are exposed to the uppermost surfaces of the first to third mesa structures 310, 330, and 350, a first electrode 270 (see FIG. 7) formed in the subsequent process may be formed to contact the second semiconductor layers 257, 237, and 217.

As shown in FIGS. 15 to 17, when a layer for preventing damage to each of the second semiconductor layers 257, 237, and 217 is present on the uppermost surface of each of the first to third mesa structures 310, 330, and 350, the first electrode 270 formed in the subsequent process may be formed to be in contact with the layer for preventing damage to each of the second semiconductor layers 257, 237, and 217.

Although the first to third light emitting devices 315, 335, and 355 are arranged side-by-side in the drawings described in FIG. 6 and the following drawings, the embodiments are not limited thereto, and the arrangement scheme of the first to third light emitting devices 315, 335, and 355 may vary depending upon a scheme of implementing the color pattern of the display apparatus 100. In addition, each of the first to third light emitting devices 315, 335, and 355 emitting different color light may correspond to a sub-pixel of the display apparatus, and the unit pixel of the display apparatus may include three or more sub-pixels. Therefore, the display apparatus 100 according to an embodiment may include, in the unit pixel, at least one of each of the first to third light emitting devices 315, 335, and 355. For example, the unit pixel of the display apparatus 100 according to an embodiment may have a structure of including three sub-pixels by including a first light emitting device 315, a second light emitting device 335, and a third light emitting device 355, or may have a structure of including four sub-pixels by including one first light emitting device 315, two second light emitting devices 335, and one third light emitting device 355.

Referring to FIG. 7, the first electrode 270 may be formed to contact the second semiconductor layer of an epitaxial structure located farthest from the first surface 211a of the first semiconductor layer 211 of the first epitaxial structure 210 with respect to each mesa structure.

That is, the first electrode 270 may be formed on each of the second semiconductor layer 257 of the third epitaxial structure 250 of the first mesa structure 310, the second semiconductor layer 237 of the second epitaxial structure 230 of the second mesa structure 330, and the second semiconductor layer 217 of the first epitaxial structure 210 of the third mesa structure 350. The first electrode 270 may be a transparent electrode formed on each of the second semiconductor layers 257, 237, and 217, for example, an indium tin oxide (ITO) electrode.

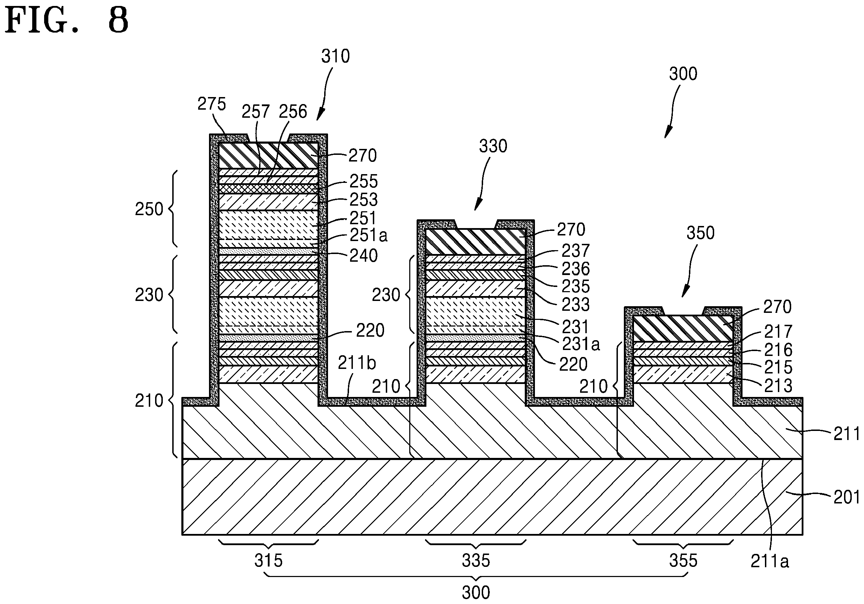

Referring to FIG. 8, after the formation of the first electrode 270, a pattern of a charge blocking layer 275 may be formed to expose at least a part of the first electrode 270 on the first to third mesa structures 310, 330, and 350 while covering the sidewalls of the first to third mesa structures 310, 330, and 350 and the exposed surface 211b of the first semiconductor layer 211 of the first epitaxial structure 210 therebetween. The charge blocking layer 275 may be formed of an Al₂O₃ and/or HfO₂ layer using, for example, an ALD process.

As shown in FIG. 8, the charge blocking layer 275 may be formed to cover the sidewalls of the first to third mesa structures 310, 330, and 350 and the exposed portion of the first semiconductor layer 211 of the first epitaxial structure 210 therebetween, and thus, a monolithic color light emitting structure 300, for example, a monolithic RGB light emitting structure, in which the first to third light emitting devices 315, 335, and 355 including the first to third color light emitting regions emitting different color light are monolithically formed may be obtained.

In this case, in the monolithic color light emitting structure 300 formed by the manufacturing process of the display apparatus according to an embodiment, the first light emitting device 315 emitting the first color light, for example, red light, may include the first mesa structure 310 in which, for example, the first epitaxial structure 210, the first junction layer 220, the second epitaxial structure 230, the second junction layer 240, and the third epitaxial structure 250 are sequentially stacked, the first electrode 270 on the upper surface of the second semiconductor layer 257 of the third epitaxial structure 250, and a common electrode to be described later. The second light emitting device 335 emitting the second color light, for example, the green light, may include the second mesa structure 330 in which, for example, the first epitaxial structure 210, the first junction layer 220, and the second epitaxial structure 230 are sequentially stacked, the first electrode 270 on the upper surface of the second semiconductor layer 237 of the second epitaxial structure 230, and a common electrode to be described later. The third light emitting device 355 emitting the third color light, for example, blue light, may include, for example, the third mesa structure 350 including the first epitaxial structure 210, the first electrode 270 on the upper surface of the second semiconductor layer 217 of the first epitaxial structure 210, and a common electrode to be described later. In addition, the sidewalls of the first to third mesa structures 310, 330, and 350 and the exposed surface 211b of the first semiconductor layer 211 of the first epitaxial structure 210 therebetween may be covered with the charge blocking layer 275.

As described above, the second mesa structure 330 may be formed by removing the third epitaxial structure 250 and the second junction layer 240 when compared with the first mesa structure 310, and the third mesa structure 350 may be formed by removing the second epitaxial structure 230 and the first junction layer 220 when compared with the second mesa structure 330. Therefore, when heights of the first to third mesa structures 310, 330, and 350 of the first to third light emitting devices 315, 335, and 355 are h1, h2, and h3, respectively, a relationship of h1>h2>h3 is established. Here, the height h1 of the first mesa structure 310 may correspond to a distance from the etched exposed surface 211b of the first semiconductor layer 211 of the first epitaxial structure 210 to the upper surface of the second semiconductor layer 257 of the third epitaxial structure 250. The height h2 of the second mesa structure 330 may correspond to a distance from the etched exposed surface 211b of the first semiconductor layer 211 to the upper surface of the second semiconductor layer 237 of the second epitaxial structure 230. The height h3 of the third mesa structure 350 may correspond to a distance from the etched exposed surface 211b of the first semiconductor layer 211 to the upper surface of the second semiconductor layer 217 of the first epitaxial structure 210.

As described above, through the manufacturing process described with reference to FIGS. 1 to 8, the monolithic color light emitting structure 300, for example, monolithic first to third light emitting devices 315, 335, and 355 may be formed on the growth substrate 201, and the first to third light emitting devices 315, 335, and 355 may have mesa structures having different heights. The first to third light emitting devices 315, 335, and 355 may be repeatedly arranged in a form of forming a two-dimensional array on the growth substrate 201. Each of the first to third light emitting devices 315, 335, and 355 may correspond to a micro light emitting device, and accordingly, when a display apparatus manufacturing process according to an embodiment is applied, a monolithic micro light emitting device display apparatus may be manufactured.

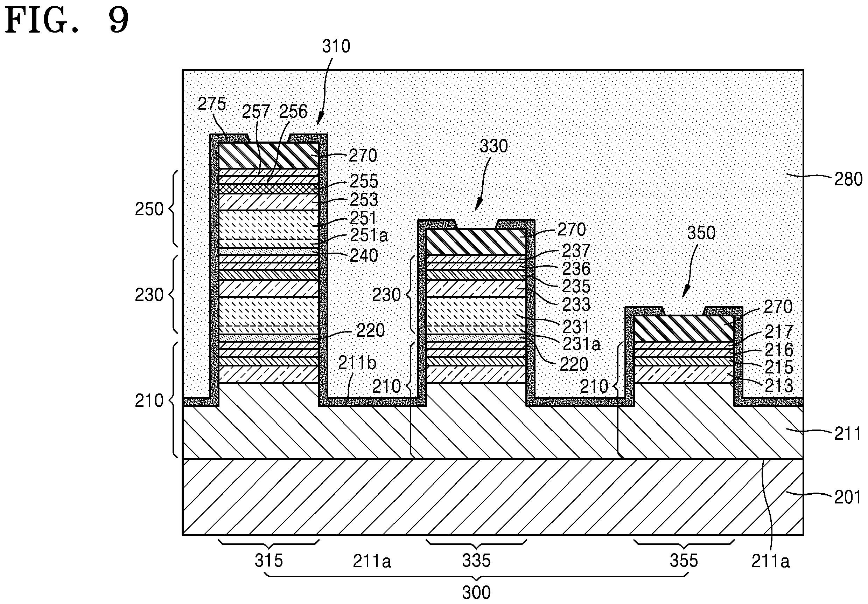

In order to manufacture a monolithic micro light emitting device display apparatus, as shown in FIGS. 9 to 11, driving transistors Tr1, Tr2, and Tr3 for respectively driving the first to third light emitting devices 315, 335, and 355 may be formed on the monolithic color light emitting structure 300.

Referring to FIG. 9, a planarized first buffer layer 280 may be formed on the monolithic color light emitting structure 300 including the two-dimensional arrangement of the first to third light emitting devices 315, 335, and 355. In order to form the planarized first buffer layer 280, a process of stacking an insulating material and a planarization process may be performed. The first buffer layer 280 may be, for example, a SiO₂ layer formed by a tetraethoxysilane (TEOS) deposition process. In addition, the first buffer layer 280 may be formed of various insulating materials. For example, the first buffer layer 280 may include SiO₂, Al₂O₃, SiN, AlN, or a combination thereof. The first buffer layer 280 may be formed through, for example, a CVD process, a PVD process, or an ALD process.

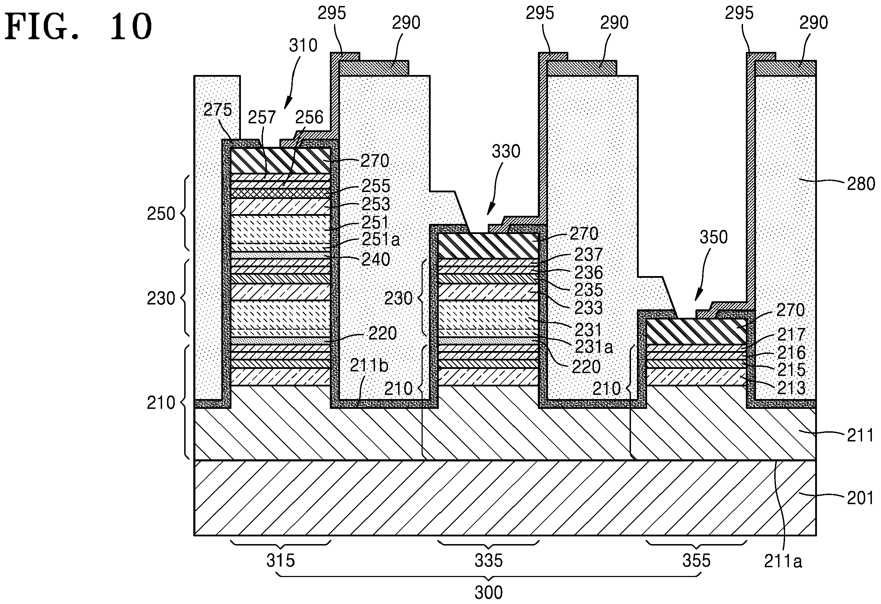

Referring to FIG. 10, the first buffer layer 280 may be patterned to expose the first electrode 270 on the first to third mesa structures 310, 330, and 350. A second electrode 290 patterned to correspond to the first electrode 270 of each of the first to third mesa structures 310, 330, and 350 may be formed on a flat top surface of the patterned first buffer layer 280, and the first electrode 270 and the corresponding second electrode 290 may be electrically connected by a contact 295. The patterned second electrode 290 may be a driving electrode (a drain electrode or a source electrode) of each driving transistor for driving each of the first to third light emitting devices 315, 335, and 355, or a contact electrode for electrical connection between the first electrode 270 of each of the first to third light emitting devices 315, 335, and 355 and the driving electrode of the corresponding driving transistor.

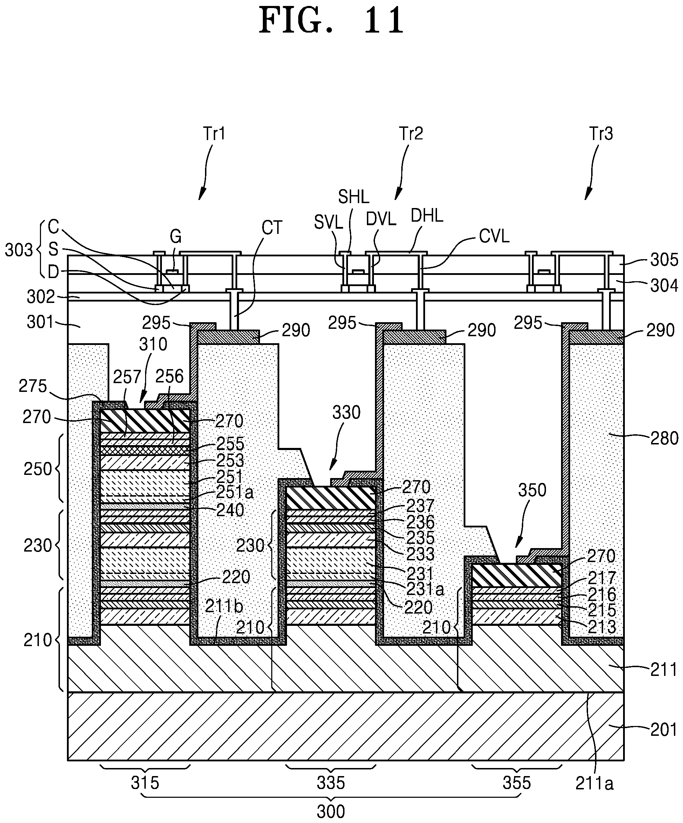

Referring to FIG. 11, in order to drive each of the first to third light emitting devices 315, 335, and 355, each of the driving transistors Tr1, TRr2, and Tr3 that are electrically connected to the second electrode 290 corresponding to the first electrode 270 on each of the first to third mesa structures 310, 330, and 350 may be formed. To this end, as shown in FIG. 11, the first insulating layer 301 may be formed to cover the monolithic color light emitting structure 300, and the driving circuit including the arrangement of the driving transistors Tr1 to Tr3 that are electrically connected to the first electrode 270 of each of the first to third mesa structures 310, 330, and 350 through the corresponding second electrode 290 may be formed.

The first insulating layer 301 may be formed as a planarization layer to completely cover the first electrodes 270 on the first to third mesa structures 310, 330, and 350 and the second electrodes 290 on the first buffer layers 280. The first insulating layer 301 may be formed by, for example, a CVD process, a PVD process, or an ALD process. The first insulating layer 301 may include, for example, SiO₂, Al₂O₃, SiN, AlN, or a combination thereof.

In order to form an arrangement of the driving transistors Tr1, Tr2, and Tr3, first, a second buffer layer 302 may be formed on the first insulating layer 301. The second buffer layer 302 may be formed by, for example, a CVD process, a PVD process, or an ALD process. The second buffer layer 302 may include an insulating material. For example, the second buffer layer 302 may include SiO₂, Al₂O₃, SiN, AlN, or a combination thereof. The second buffer layer 302 may serve as a growth substrate for forming a driving circuit. As another example, it is possible to have a structure without the second buffer layer 302, and the first insulating layer 301 may serve as a growth substrate for forming a driving circuit. Although an example of providing the second buffer layer 302 on the first insulating layer 301 is illustrated in the drawings, the embodiments are not limited thereto.

Contact CTs via the second buffer layer 302 and the first insulating layer 301 may be formed. The contacts CTs may be electrically connected to the first electrodes 270 on the first to third mesh structures 310, 330, and 350 through the corresponding second electrodes 290, respectively. For example, the contacts CTs may be formed to contact the corresponding second electrodes 290, respectively. The contacts CTs may be formed by forming openings (not shown) through the second buffer layer 302 and the first insulating layer 301 to expose the second electrodes 290, respectively, and then filling the openings with a conductive material. Although the drawings illustrate that the conductive material completely fills the openings, this is only an example. In another example, a part of the conductive material may extend along the surfaces of the first insulating layer 301 and the second buffer layer 302 exposed by the openings, and may not completely fill the openings. The upper portions of the contacts CTs may be exposed on the second buffer layer 302.

Semiconductor patterns 303 of the driving transistors Tr1, Tr2, and Tr3 may be formed on the second buffer layer 302. Each of the semiconductor patterns 303 may include a source region S, a drain region D, and a channel region C. The semiconductor patterns 303 may be formed by forming amorphous semiconductor patterns on the second buffer layer 302 and irradiating and crystallizing both ends of the amorphous semiconductor patterns with laser. For example, the amorphous semiconductor patterns may include amorphous silicon. Both crystallized ends of each of the semiconductor patterns 303 may be defined as a source region S and a drain region D. A portion between both ends of each of the semiconductor patterns 303 may be amorphous. An amorphous portion of each of the semiconductor patterns 303 may be defined as a channel region C. The semiconductor patterns 303 may be respectively provided on the first to third mesa structures 310, 330, and 350 corresponding thereto, but embodiments are not limited thereto. In other words, each of the semiconductor patterns 303 may overlap a corresponding mesa structure along a direction perpendicular to the growth substrate 201. However, embodiments are not limited thereto. For example, the semiconductor patterns 303 may be provided on the regions between the mesa structures, respectively.

A second insulating layer 304 may be formed on the semiconductor patterns 303, the second buffer layer 302, and the contacts CT. The second insulating layer 304 may be formed by, for example, a CVD process, a PVD process, or an ALD process. The second insulating layer 304 may be formed to entirely cover the semiconductor patterns 303, the second buffer layer 302, and the contacts CT. The second insulating layer 304 may include SiO₂, Al₂O₃, SiN, AlN, or a combination thereof. The second insulating layer 304 may function as a gate insulating layer.

In addition, gate electrodes G may be formed on the second insulating layer 304. The gate electrodes G may be formed by forming a gate electrode layer (not shown) extending along the second insulating layer 304 and patterning the gate electrode layer. The gate electrode layer may be formed by, for example, a CVD process, a PVD process, or an ALD process. The gate electrode layer may include, for example, a conductive material, such as metal or polysilicon. The gate electrodes G may be provided on opposite sides of the channel regions C with respect to the second insulating layer 304, respectively. In other words, the gate electrodes G may be arranged to overlap the channel regions C in the vertical direction of the growth substrate 201.

A third insulating layer 305 may be formed on the gate electrodes G and the second insulating layer 304. The third insulating layer 305 may be formed by, for example, a CVD process, a PVD process, or an ALD process. The third insulating layer 305 may be formed to entirely cover the gate electrodes G and the second insulating layer 304. The third insulating layer 305 may include SiO₂, Al₂O₃, SiN, AlN, or a combination thereof.

Thereafter, drain vertical lines DVLs via the second insulating layer 304 and the third insulating layer 305 may be formed. The drain vertical lines DVLs may include, for example, a conductive material, such as metal. The drain vertical lines DVLs may be formed by forming openings via the second insulating layer 304 and the third insulating layer 305 to expose the drain regions D, respectively, and providing a conductive material in the openings. Although the drawings illustrate that the conductive material provided for the openings completely fills the openings, this is only an example. In another example, the conductive material may extend along the surfaces of the second insulating layer 304 and the third insulating layer 305 exposed by the openings, and may not completely fill the openings. The drain vertical lines DVLs may be electrically connected to the drain regions D, respectively. For example, each of the drain vertical lines DVLs may be in direct contact with a corresponding drain region D.

Drain horizontal lines DHLs may be formed on the drain vertical lines DVLs, respectively. Drain horizontal lines DHLs may be formed together when the drain vertical lines DVLs are formed. For example, when a conductive material is provided in openings for forming drain vertical lines DVLs, a conductive material may be provided on the upper surface of the third insulating layer 305. The conductive material provided on the upper surface of the third insulating layer 305 and directly contacting the drain vertical lines DVLs may be defined as the drain horizontal lines DHLs. The drain regions D may be electrically connected to the data driver described with reference to FIGS. 1 and 2 by drain vertical lines DVLs and drain horizontal lines DHLs.

In addition, source vertical lines SVLs and contact vertical lines CVLs via the second insulating layer 304 and the third insulating layer 305 may be formed. The source vertical lines SVLs and the contact vertical lines CVLs may be formed together when the drain vertical lines DVLs are formed. The source vertical lines SVLs and the contact vertical lines CVLs may include, for example, a conductive material, such as metal. The source vertical lines SVLs and the contact vertical lines CVLs may be formed by form openings via the second insulating layer 304 and the third insulating layer 305 to expose the source regions S and the contacts CT, respectively, and providing a conductive material in the openings. Although the drawings illustrate that the conductive material provided for the openings completely fills the openings, this is only an example. In another example, the conductive material may extend along the surfaces of the second insulating layer 304 and the third insulating layer 305 exposed by the openings, and may not even completely fill the openings. The source vertical lines SVLs may be electrically connected to the source regions S, respectively. For example, each of the source vertical lines SVLs may directly contact the corresponding source region S. In addition, the contact vertical lines CVLs may be electrically connected to the contacts CTs, respectively. For example, each of the contact vertical lines CVLs may be in direct contact with a corresponding contact CT.

Source horizontal lines SHLs may be formed on the source vertical lines SVLs, respectively. The source horizontal lines SHLs may be formed together when the source vertical lines SVL are formed. For example, when a conductive material is provided in openings for forming source vertical lines SVLs, a conductive material may be provided on the upper surface of the third insulating layer 305. The conductive material provided on the upper surface of the third insulating layer 305 and directly contacting the source vertical lines SVLs may be defined as source horizontal lines SHLs.

The drain horizontal lines DHLs may extend on the contact vertical lines CVLs along the horizontal direction. Each of the drain horizontal lines DHLs may electrically connect the drain vertical line DVL and the contact vertical line CVL, which are immediately adjacent to each other. For example, both ends of each of the drain horizontal lines DHLs may be in direct contact with the drain vertical line DVL and the contact vertical line CVL, which are immediately adjacent to each other.

FIG. 11 shows an example in which the drain region D 1 is electrically connected to the second electrode 290 through the drain vertical line DVL, the drain horizontal line DHL, the contact vertical line CVL, and the contact CT, and accordingly, the first electrode 270 of each of the first to third light emitting devices 315, 335, and 355 is electrically connected to the drain region D, but the embodiments are not limited thereto. For example, in FIG. 11, the source region S and the drain region D may be interchanged, and the source horizontal lines SHLs may be provided to extend onto the contact vertical lines CVLs along the horizontal direction, and thus, the source region S may be electrically connected to the first electrode 270 of each of the first to third light emitting devices 315, 335, and 355.

The channel region C, the source region S, the drain region D, and the gate electrode G may form each of the driving transistors Tr1, Tr2, and Tr3. When the display apparatus 100 is driven, the driving transistors Tr1, Tr2, and Tr3 may control the light emission operations of the active layers of the uppermost epitaxial structures of the first to third mesa structures 310, 330, and 350 of the corresponding first to third light emitting devices 315, 335, and 355, which are electrically connected thereto.

For example, in the first mesa structure 310 of the first light emitting device 315 electrically connected to the driving transistor Tr1, the driving transistor Tr1 may control the light emission operation of the active layer 255 of the third epitaxial structure 250 located at the uppermost position. In the first mesa structure 310, carrier transmission to the active layer 235 of the second epitaxial structure 230 and the active layer 215 of the first epitaxial structure 210 located below may be blocked by the first carrier blocking layer 253 of the third epitaxial structure 250.

In the first mesa structure 330 of the second light emitting device 335 electrically connected to the driving transistor Tr2, the driving transistor Tr2 may control the light emission operation of the active layer 235 of the second epitaxial structure 230 located at the uppermost position. In the second mesa structure 330, carrier transmission to the active layer 215 of the first epitaxial structure 210 located below is blocked by the first carrier blocking layer 233 of the second epitaxial structure 230.

In the third mesa structure 350 of the third light emitting device 355 electrically connected to the driving transistor Tr3, the driving transistor Tr3 may control the light emission operation of the active layer 215 of the first epitaxial structure 210 located at the uppermost position. That is, the third mesa structure 350 of the third light emitting device 355 includes only the first epitaxial structure 210, and the driving transistor Tr3 may control the light emission operation of the active layer 215 of the first epitaxial structure 210.

Accordingly, a first sub-pixel area SP1, a second sub-pixel area SP2, and a third sub-pixel area SP 3 arranged along the horizontal direction may be defined. The driving transistors Tr1, TR2, and Tr3 and the first to third mesa structures 310, 330, and 350 of the first to third light emitting devices 315, 335, and 355, which are electrically connected to the driving transistors Tr1, TR2, and Tr3, respectively, may be provided in the first to third sub-pixel areas SP1, SP2, and SP3, respectively.

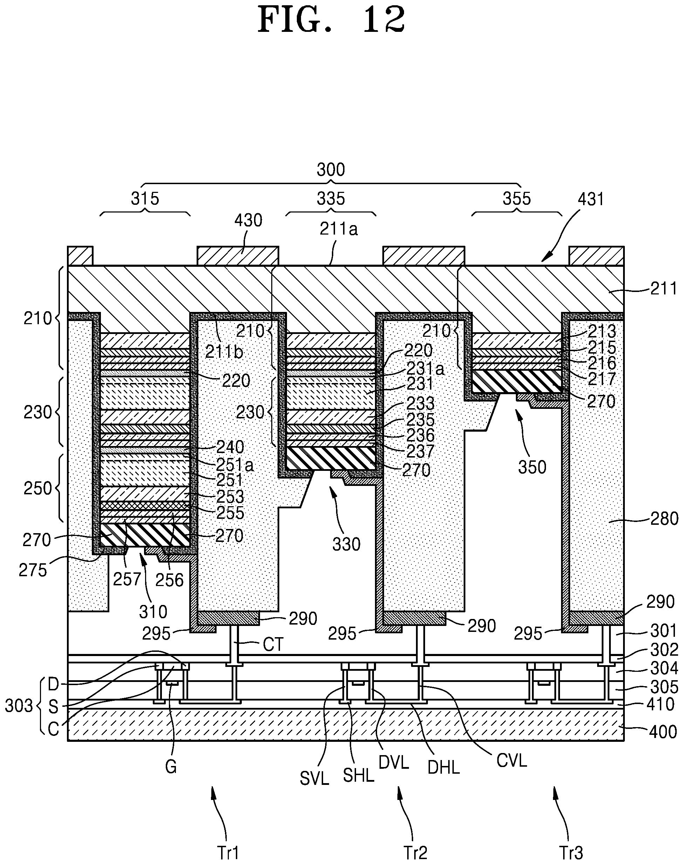

Referring to FIG. 12, a product including the monolithic color light emitting structure 300 and the array of the driving transistors Tr1, Tr2, and Tr3, which are formed so far is arranged on a support substrate 400 such that the growth substrate 201 faces upward, and is bonded to the support substrate 400, to then remove the growth substrate 201, and form patterned common electrodes 430. The product may be fixed to the support substrate 400 by a flip-chip bonding process. When the first semiconductor layer 211 of the first epitaxial structure 210 is formed of an n type group III-V compound semiconductor, for example, n-GaN, the patterned common electrodes 430 may be N-common electrodes.

When the formed product is arranged on the support substrate 400 such that the growth substrate 201 faces upward, the growth substrate 201 may be located at the uppermost portion, and the drain horizontal lines DHLs and the source horizontal lines SHLs may be located at the lowermost portion. According to an embodiment, the support substrate 400 may be directly bonded to the third insulating layer 305, the drain horizontal lines DHLs, and the source horizontal lines SHLs. According to another embodiment, an adhesive layer 410 may be further provided between the support substrate 400, and the third insulating layer 305, the drain horizontal line DHL and the source horizontal line SHL, and the third insulating layer 305, the drain horizontal line DHL, and the source horizontal line SHL may be fixed on the support substrate 400 through the adhesive layer 410. The support substrate 400 may be, for example, a silicon substrate or a glass substrate. FIG. 12 illustrates an example in which the product including the third insulating layer 305, the drain horizontal line DHL, and the source horizontal line SHL is fixed to the support substrate 400 through the adhesive layer 410.

As described above, in a state in which the product is fixed to the support substrate 400, the growth substrate 201 may be removed. When the growth substrate 201 is a semiconductor substrate, the growth substrate 201 may be removed by a polishing process and/or an etching process. For example, the etching process may be a dry etching process. The etching process may be performed by a reactive ion etching (RIE) process. When the growth substrate 201 is a sapphire substrate, the growth substrate 201 may be removed by, for example, a laser lift-off process. The growth substrate 201 may be removed to expose the first semiconductor layer 211 of the first epitaxial structure 210. When the buffer layer is provided on the growth substrate 201, the growth substrate 201 may be removed, and then the buffer layer may be removed through an etching process. Accordingly, the first semiconductor layer 211 of the first epitaxial structure 210 may be exposed to the outside.

The common electrodes 430 patterned may be formed on the upper surface of the first semiconductor layer 211 of the first epitaxial structure 210 exposed by removing the growth substrate 201, for example, the first surface 211a. For example, after the common electrode layer is formed on the first surface 211a of the first semiconductor layer 211 of the first epitaxial structure 210 through a CVD process, a PVD process, or an ALD process, the common electrode layer may be patterned to partially expose the first surface 211a of the first semiconductor layer 211, thereby forming the common electrodes 430. As illustrated in FIG. 12, when the common electrodes 430 are formed at positions corresponding to the in-between regions of the first to third mesa structures 310, 330, and 350, and when openings are respectively formed in regions corresponding to the first to third light emitting devices 315, 335, and 355, the common electrodes 430 may include, for example, an opaque conductive metal material. As another example, each of the common electrodes 430 may be formed as a transparent electrode, and in this case, the common electrodes 430 may be formed to include regions corresponding to the first to third light emitting devices 315, 335, and 355. Here, an example in which the common electrodes 430 are formed at positions corresponding to the in-between regions of the first to third mesa structures 310, 330, and 350 will be described, but the embodiments are not limited thereto.

The common electrodes 430 may be respectively located at positions overlapping the in-between regions of the first to third mesa structures 310, 330, and 350, for example. The width of each of the common electrodes 430 may be equal to or larger than or smaller than the width of each of the in-between regions of the first to third mesa structures 310, 330, and 350, for example. Although the plurality of common electrodes 430 are shown as being arranged at regular intervals in the drawings, the common electrode 430 may actually be a single layer having a mesh shape. Alternatively, a plurality of separate common electrodes 430 may be arranged on the first to third sub-pixel areas SP1, SP2, and SP3, respectively. A plurality of opening regions 431 formed to partially expose the first surface 211a of the first semiconductor layer 211 of the first epitaxial structure 210 may be arranged two-dimensionally between the common electrodes 430.

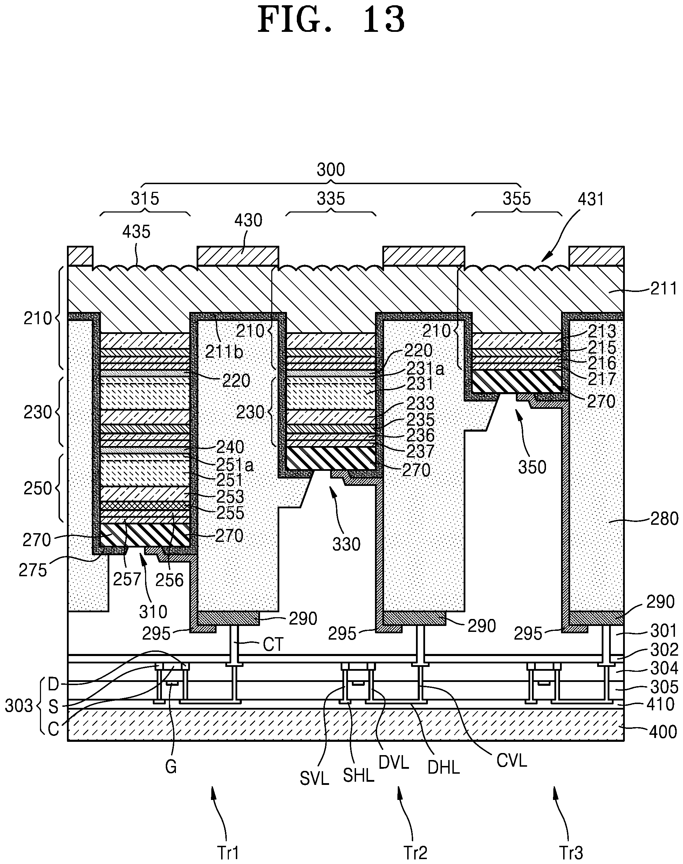

Referring to FIG. 13, regions of the first surface 211a of the first semiconductor layer 211, not covered by the common electrode 430 may correspond to opening regions 431. An uneven light extraction pattern 435 may be formed on the bottom surfaces of the opening regions 431, that is, in the opening regions 431, on the first surface 211a of the first semiconductor layer 211. FIG. 13 shows an example in which the light extraction pattern 435 is formed in the opening region 431 of the first surface 211a of the first semiconductor layer 211 on which the common electrode 430 is disposed, but the embodiments are not limited thereto. For example, a partial depth of the first semiconductor layer 211 may be removed in the opening region so as to be lowered from the first surface 211a of the first semiconductor layer 211 on which the common electrode 430 is disposed, and the light extraction pattern 435 may be formed on the lowered surface of the first semiconductor layer 211.

The light extraction pattern 435 may be formed using a potassium hydroxide (KOH) solution or a tetramethyl ammonium hydroxide (TMAH) solution as an etchant. The light extraction pattern 435 may be provided in each of the first to third sub-pixel areas SP1, SP2, and SP3, and may be disposed to face the active layers 255, 235, and 215 in which light of the first to third light emitting devices 315, 335, and 355 is generated. The light extraction pattern 435 may allow light generated from each of the active layers 255, 235, and 215 to be easily emitted to the outside through the opening regions 431, thereby increasing light extraction efficiency. In addition, the light extraction pattern 435 may allow light emitted to the outside to have a spatially homogeneous intensity distribution.

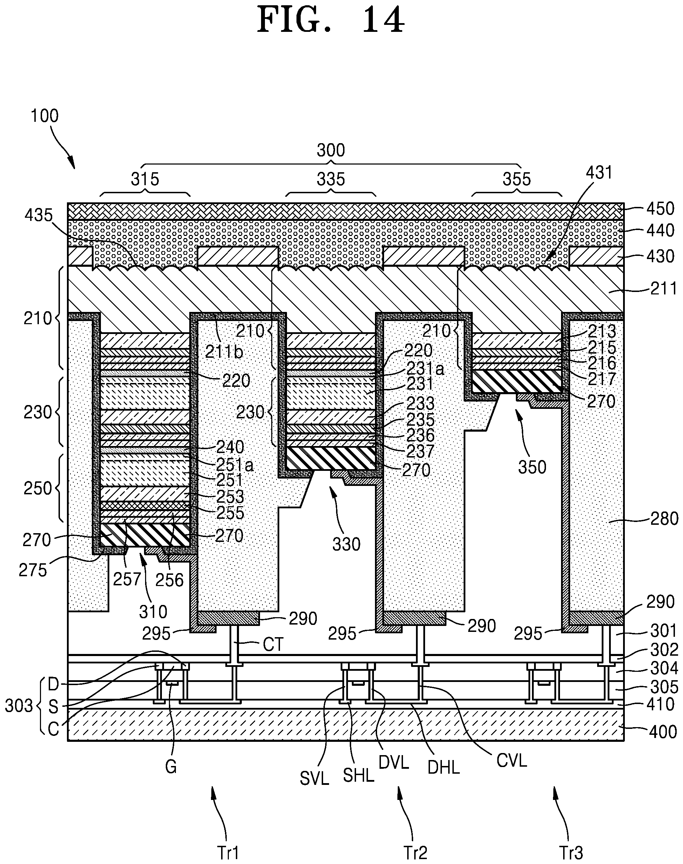

Referring to FIG. 14, a transparent fourth insulating layer 440 may be formed to cover both the common electrode 430 and the opening regions 431 in which the light extraction pattern 435 is formed. The fourth insulating layer 440 may have transmittance with respect to light emitted from the first to third light emitting devices 315, 335, and 355. For example, the fourth insulating layer 440 may include SiO₂, Al₂O₃, SiN, AlN, or a combination thereof. The fourth insulating layer 440 may have a flat surface. An encapsulation layer 450 may be further formed on the fourth insulating layer 440. The encapsulation layer 450 may include an insulating material. For example, the encapsulation layer may include SiO₂, Al₂O₃, SiN, AlN, or a combination thereof, or a transparent plastic material, or glass.

Through the above-described method, the display apparatus 100 according to an embodiment may be manufactured. As described with reference to FIGS. 3 to 14, the display apparatus 100 according to the embodiment may be manufactured by applying the first to third mesa structures 310, 330, and 350 in which the first electrode 270 is in contact with the second semiconductor layers 257, 237, and 217. In addition, as described with reference to FIGS. 15 to 17, the display apparatus 100 according to the embodiment may be manufactured by applying the first to third mesa structures 310, 330, and 350 in which a layer for preventing damage to each of the second semiconductor layers 257, 237, and 217 is present between the first electrode 270 and the second semiconductor layers 257, 237, and 217 of the first to third mesa structures 310, 330, and 350.

Referring to FIGS. 12 to 14, in the display apparatus 100 according to the embodiment, light emitting devices of a plurality of subpixels SP are formed in a vertical stack epitaxial structure on one growth substrate.

The display apparatus 100 according to an embodiment may include a support substrate 400, and a stacked structure of the plurality of driving transistors Tr1 to Tr3, and the monolithic color light emitting structure 300, which are formed on the support substrate 400, and the monolithic color light emitting structure 300 may include a plurality of monolithic light emitting devices having a plurality of mesa structures having different heights. The plurality of driving transistors Tr1, Tr2, and Tr3 may be electrically connected to a plurality of mesa structures corresponding to driving the plurality of light emitting devices, respectively. The array of the plurality of driving transistors Tr1, Tr2, and Tr3 and the monolithic color light emitting structure 300 may be formed in a monolithic form. For example, the plurality of light emitting devices of the monolithic color light emitting structure 300 and the plurality of driving transistors Tr1, Tr2, and Tr3 may be formed on one growth substrate. As another example, the plurality of light emitting devices of the monolithic color light emitting structure 300 and the plurality of driving transistors Tr1, Tr2, and Tr3 may be formed on different growth substrates.

The monolithic color light emitting structure 300 may include the first surface 211a through which light is emitted and the plurality of mesa structures spaced apart from each other on a second surface opposite to the first surface, and thus may include a plurality of light emitting devices (e.g., first to third light emitting devices 315, 335, and 355) emitting a plurality of beams of different color light.

The plurality of mesa structures may include a mesa structure including a first epitaxial structure 210, and at least one mesa structure including a vertical stack of a first epitaxial structure 210 and at least one epitaxial structure, such that at least two mesa structures have different heights.

For example, the plurality of mesa structures may include a first mesa structure 310 including a vertical stack of the first to third epitaxial structures 210, 230, and 250, a second mesa structure 330 including a vertical stack of the first epitaxial structure 210 and the second epitaxial structure 230, and a third mesa structure 350 including the first epitaxial structure 210.

Each of the first to third epitaxial structures 210, 230, and 250 has a sequential stack structure of the first conductive type first semiconductor layer 211, 231, or 251, the carrier blocking layer 213, 233, or 253, the active layer 215, 235, or 255, and the second conductive type second semiconductor layer 217, 237, or 257 in a direction away from the first surface 211a, and may be provided such that carriers, for example, holes moved from the second semiconductor layer 217, 237, or 257 toward the first semiconductor layer 211, 231, or 251 are blocked by the carrier blocking layer 213, 233, or 253. In addition, the active layers 215, 235, and 255 of the first to third epitaxial structures 210, 230, and 250 are provided to have different optical wavelengths from each other. Accordingly, each of the first to third mesa structures 310, 330, and 350 forms first to third light emitting devices 315, 335, and 355 that generate and emit light of a corresponding wavelength in an active layer of the epitaxial structure located farthest from the first surface 211a.

The first surface 211a of the monolithic color light emitting structure 300 may correspond to, as a surface exposed after removing the growth substrate 201, one surface of the first semiconductor layer 211 of the first epitaxial structure 210, and the first to third light emitting devices 315, 335, and 355 may be connected through a part of the thickness portion of the first semiconductor layer 211 of the first epitaxial structure 210 to constitute a monolithic form. The common electrode 430 may be formed on the first surface 211a. The common electrode 430 may be patterned to form a plurality of opening regions 431 emitting light generated by the first to third light emitting devices 315, 335, and 355 on the first surface 211a. In addition, the light extraction pattern 435 may be further provided in at least some of the plurality of opening regions 431, to increase light extraction efficiency. The light extraction pattern 435 may be an uneven pattern formed on the first surface 211a in the opening region 431, or may be an uneven pattern formed on a surface of the first semiconductor layer 211 lowered by removing a partial depth of the first semiconductor layer 211 in the opening region 431 by a predetermined depth to be located more inwards than the first surface 211a. The light extraction pattern 435 may be formed of another material in the opening region 431.

Each of the first to third epitaxial structures 210, 230, and 250 may further include the carrier blocking layers 216, 236, and 256, which block carriers, for example, electrons moving from the first semiconductor layers 211, 231, and 251 toward the second semiconductor layer 217, 237, and 257, between the active layers 215, 235, and 255 and the second semiconductor layers 217, 237, and 257.

In addition, a high-concentration doped junction layer may be further provided in the same first conductive type as those of the first semiconductor layers, between the second semiconductor layers of one epitaxial structure and the first semiconductor layers of another epitaxial structure, which are adjacent to each other, to form a tunnel junction between the epitaxial structures adjacent to each other in the vertical direction. For example, the first junction layer 220 may be further provided between the second semiconductor layer 217 of the first epitaxial structure 210 and the first semiconductor layer 231 of the second epitaxial structure 230, and/or the second junction layer 240 may be further provided between the second semiconductor layer 237 of the second epitaxial structure 230 and the first semiconductor layer 251 of the third epitaxial structure 250.

In the monolithic color light emitting structure 300 may further include a first electrode 270 such that each of the first to third mesa structures 310, 330, and 350 may further include the first electrode 270 in contact with a second semiconductor layer of an epitaxial structure located farthest from the first surface 211a. That is, in the first mesa structure 310, the first electrode 270 may be formed to contact the second semiconductor layer 257 of the third epitaxial structure 250. In the second mesa structure 330, the first electrode 270 may be formed to contact the second semiconductor layer 237 of the second epitaxial structure 230. In the third mesa structure 350, the first electrode 270 may be formed to contact the second semiconductor layer 217 of the first epitaxial structure 210. The first electrode 270 may be a transparent electrode formed on a surface of each of the second semiconductor layers 217, 237, and 257.

The display apparatus 100 according to an embodiment may include, for example, first to third sub-pixel areas SP1, SP2, and SP3. One driving transistor and a first light emitting device 315 emitting first color light, for example, red light may be arranged in the first sub-pixel area SP1, one driving transistor and a second light emitting device 335 emitting second color light, for example, green light may be arranged in the second sub-pixel area SP2, and one driving transistor and a first light emitting device 315 emitting third color light, for example, blue light may be arranged in the first sub-pixel area SP3. The plurality of first to third sub-pixel areas SP1, SP2, and SP3 having such a structure may be two-dimensionally arranged.

As described above, the display apparatus 100 may further include the common electrode 430 disposed on a surface from which the growth substrate 201 of the first semiconductor layer 211 of the first epitaxial structure 210 is removed, that is, the first surface 211a. The common electrode 430 may be a single layer having a mesh shape, or a plurality of separate common electrodes 430 may be separately arranged with respect to the first to third sub-pixel areas SP1, SP2, and SP3. The common electrode 430 may include an opaque metal material.

In the array of the plurality of the monolithic light emitting devices 315, 335 and 355, the spacing between the mesa structures 310, 330, and 350 may be equal to or larger than or smaller than the width of the active layer of the mesa structure, and each of the light emitting devices 315, 335 and 355 may be a micro light emitting device. For example, the width of the active layer along the horizontal direction in the mesa structures 310, 330, and 350 may be in a range from about 0.1 µm to about 100 µm. Accordingly, with reference to the display apparatus 100 according to the embodiment, the micro light emitting device display apparatus may be manufactured by a monolithic color light emitting structure 300.

According to the method of manufacturing the display apparatus 100 described above, since a plurality of light emitting devices 315, 335, and 355 emitting different color light are formed in a monolithic form on the growth substrate 201, or a stacked structure of the plurality of light emitting devices 315, 335, and 355 and the driving transistors is formed, a high-level transfer technology is not required. Accordingly, the manufacturing cost and manufacturing time of the display apparatus 100 may be reduced. In addition, since a plurality of light emitting devices 315, 335, and 355 emitting different color light are formed of a monolithic color light emitting structure 300, a manufacturing process of the color conversion layer for color implementation is not required, thereby further reducing the manufacturing cost of the display apparatus 100. Accordingly, the display apparatus 100 may have, for example, a high resolution of 5000 ppi (pixel per inch) or higher or an ultra-high resolution of 10,000 ppi or higher. The display apparatus 100 according to the embodiment may be applied to various displays, such as, for example, an augmented reality oriented micro display.

In the above description, the display apparatus 100 has been described and illustrated as being formed by bonding a structure in which the driving transistors Tr1 to Tr3 are stacked on the monolithic color light emitting structure 300 to the support substrate 400, but embodiments of the present disclosure are not limited thereto. For example, the display apparatus 100 according to the embodiment may be obtained by applying a support substrate on which the backplane of the driving transistors Tr1, Tr2, and Tr3 is formed, thereby bonding, for example, flip-bonding the monolithic color light emitting structure 300 to the supporting substrate.

The display apparatus 100 may further include a color filter, and in this case, the color purity of the display apparatus 100 may be further improved.

The display apparatus 100 may be applied to various electronic devices having a screen display function.

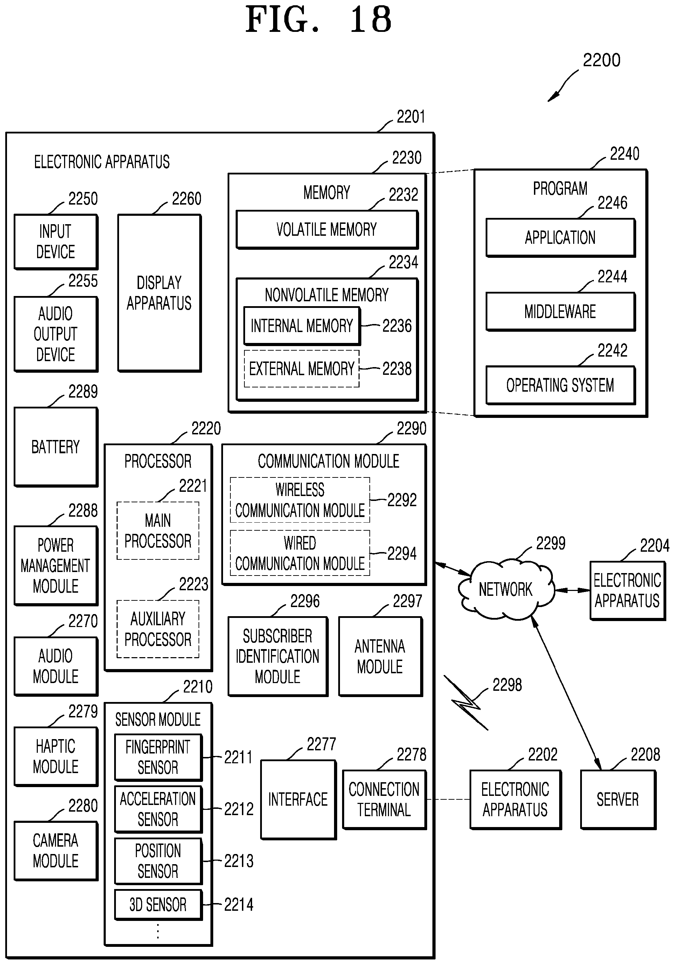

FIG. 18 is a block diagram illustrating a schematic configuration of an electronic apparatus according to an embodiment.

Referring to FIG. 18, in a network environment 2200, the electronic apparatus 2201 may communicate with another electronic apparatus 2202 through a first network 2298 (a short-range wireless communication network or the like), or with another electronic apparatus 2204 and/or a server 2208 through a second network 2299 (a long-range wireless communication network or the like). The electronic apparatus 2201 may communicate with the electronic apparatus 2204 through the server 2208. The electronic apparatus 2201 may include a processor 2220, a memory 2230, an input device 2250, an audio output device2255, a display apparatus 2260, an audio module 2270, a sensor module 2210, an interface 2277, a haptic module 2279, a camera module 2280, a power management module 2288, a battery 2289, a communication module 2290, a subscriber identification module 2296, and/or an antenna module 2297. Some of these components may be omitted from or other components may be added to the electronic apparatus 2201. Some of these components may be implemented as one integrated circuit. For example, a fingerprint sensor 2211, an iris sensor, an illumination sensor, etc., of the sensor module 2210 may be embedded in the display apparatus 2260. In addition, the camera module 2280, the haptic module 2279, and the sensor module 2210 may include a part of the processor 2220 and/or the memory 2230, respectively.

The processor 2220 may execute software (e.g., program 2240) to control one or a plurality of other components (e.g., hardware and/or software components) of the electronic apparatus 2201 connected to the processor 2220, and may perform various data processing or operations. As part of data processing or operation, the processor 2220 may load commands and/or data received from other components (e.g., sensor modules 2210 and/or communication modules 2290) in volatile memory 2232, process commands and/or data stored in volatile memory 2232, and store the result data in nonvolatile memory 2234. The processor 2220 may include a main processor 2221 (e.g., a central processing unit and/or an application processor) and an auxiliary processor 2223 (e.g., a graphics processing unit, an image signal processor, a sensor hub processor, and/or a communication processor) that may be operated independently of or together with the main processor 2221. The auxiliary processor 2223 may use less power than the main processor 2221 and perform a specialized function.

The auxiliary processor 2223 may control the functionality and/or status associated with some of the components of the electronic apparatus 2201 (e.g., the display apparatus 2260, the sensor module 2210, and/or the communication module 2290), in place of the main processor 2221 while the main processor 2221 is in an inactive state (e.g., sleep state), or in conjunction with the main processor 2221 while the main processor 2221 is in an active state (e.g., application execution state). The auxiliary processor 2223 (e.g., image signal processor and/or communication processor) may be implemented as part of other functionally related components (e.g., camera module 2280 and/or communication module 2290).

The memory 2230 may store various data required by components (e.g., processor 2220 and/or sensor module 2276) of the electronic apparatus 2201. The data may include, for example, input data and/or output data for software (e.g., program 2240) and related commands. The memory 2230 may include a volatile memory 2232 and/or a nonvolatile memory 2234.

The program 2240 may be stored in the memory 2230 as software, and may include an operating system 2242, middleware 2244, and/or an application 2246.

The input apparatus 2250 may receive commands and/or data to be used in components (e.g., processor 2220) of the electronic apparatus 2201 from the outside (e.g., a user) of the electronic apparatus 2201. The input apparatus 2250 may include a microphone, a mouse, a keyboard, and/or a digital pen (such as a stylus pen).

The audio output apparatus 2255 may output the sound signal to the outside of the electronic apparatus 2201. The audio output apparatus 2255 may include a speaker and/or a receiver. Speakers may be used for general purposes such as multimedia playback or recording playback, and receivers may be used to receive incoming calls. The receiver may be coupled as part of a speaker or may be implemented as an independent separate device.

The display apparatus 2260 may visually provide information to the outside of the electronic apparatus 2201. The display apparatus 2260 may include the display apparatus 100 according to the above-described embodiment. The display apparatus 2260 may include a display, a hologram device, or a projector and a control circuit for controlling the corresponding device. The display device 2260 may include a touch circuit configured to sense a touch, and/or a sensor circuit (e.g., a pressure sensor) configured to measure an intensity of a force generated by the touch.

The audio module 2270 may convert sound into an electrical signal or conversely convert the electrical signal into sound. The audio module 2270 may acquire sound through the input apparatus 2250 or output sound through the audio output apparatus 2255 and/or a speaker and/or a headphone of another electronic apparatus (e.g., electronic apparatus 2102) directly or wirelessly connected to the electronic apparatus 2201.

The sensor module 2210 may detect an operating state (e.g., power, and/or temperature) or an external environmental state (e.g., user state) of the electronic apparatus 2201 and generate an electrical signal and/or a data value corresponding to the sensed state. The sensor module 2210 may include a fingerprint sensor 2211, an acceleration sensor 2212, a position sensor 2213, a three-dimensional (3D) sensor 2214 and the like, and may also include an iris sensor, a gyro sensor, a barometric sensor, a grip sensor, a proximity sensor, a color sensor, an infrared (IR) sensor, a biometric sensor, a temperature sensor, a humidity sensor, and/or an illumination sensor.

The 3D sensor 2214 senses the shape, movement, and the like of an object by irradiating predetermined light to the object and analyzing the light reflected from the object. For example, an imaging optical system and an imaging device including the same may be applied thereto.

The interface 2277 may support one or more designated protocols that may be used for electronic apparatus 2201 to be directly or wirelessly connected to another electronic apparatus (e.g., electronic apparatus 2102). The interface 2277 may include a high definition multimedia interface (HDMI), a universal serial bus (USB) interface, an SD card interface, and/or an audio interface.

The connection terminal 2278 may include a connector through which the electronic apparatus 2201 may be physically connected to another apparatus (e.g., electronic apparatus 2102). The connection terminal 2278 may include an HDMI connector, a USB connector, an SD card connector, and/or an audio connector (such as a headphone connector).

The haptic module 2279 may convert an electrical signal to a mechanical stimulus (e.g., vibration and/or motion) or an electrical stimulus that a user can recognize through a tactile or motion sensation. The haptic module 2279 may include a motor, a piezoelectric element, and/or an electrical stimulus.

The camera module 2280 may capture a still image and a moving image. The camera module 2280 may include an imaging optical system including one or more lenses, image sensors, image signal processors, and/or flashes. The imaging optical system included in the camera module 2280 may collect light emitted from an object to be photographed.

The power management module 2288 may manage power supplied to the electronic apparatus 2201. The power management module 2288 may be implemented as part of a power management integrated circuit (PMIC).

The battery 2289 may supply power to components of the electronic apparatus 2201. The battery 2289 may include a non-rechargeable primary battery, a rechargeable secondary battery, and/or a fuel cell.

The communication module 2290 may establish a direct (wired) communication channel and/or wireless communication channel between the electronic apparatus 2201 and another electronic apparatus (e.g., the electronic apparatus 2102, the electronic apparatus 2104, and/or the server 2108), and support communication execution through the established communication channel. The communication module 2290 may include one or more communication processors that operate independently of the processor 2220 (e.g., application processor) and support direct communication and/or wireless communication. The communication module 2290 may include a wireless communication module 2292 (e.g., a cellular communication module, a short-range wireless communication module, and/or a GNSS (Global Navigation Satellite System, etc.) communication module), and/or a wired communication module 2294 (e.g., a local area network (LAN) communication module, and/or a power line communication module). A corresponding communication module of these communication modules may communicate with other electronic apparatuses through a first network 2298 (e.g., a short-range communication network such as Bluetooth, WiFi Direct, or infrared data association (IrDA)), or a second network 2299 (e.g., a long-range communication network such as a cellular network, Internet, or computer network (LAN and/or WAN)). These various types of communication modules may be integrated into a single component (such as a single chip, etc.), or may be implemented as a plurality of separate components (e.g., multiple chips). The wireless communication module 2292 may identify and authenticate the electronic apparatus 2201 in a communication network such as a first network 2298 and/or a second network 2299 using subscriber information (such as an international mobile subscriber identifier (IMSI) stored in the subscriber identification module 2296.

The antenna module 2297 may transmit a signal and/or power to the outside (such as another electronic apparatus) or receive the signal and/or power from the outside. The antenna may include a radiator formed of a conductive pattern formed on the substrate (e.g., PCB). The antenna module 2297 may include one or a plurality of antennas. When a plurality of antennas are included, an antenna suitable for a communication scheme used in a communication network such as a first network 2298 and/or a second network 2299 may be selected from among the plurality of antennas by the communication module 2290. A signal and/or power may be transmitted or received between the communication module 2290 and another electronic apparatus through the selected antenna. Other components (e.g., RFIC) in addition to the antenna may be included as a part of the antenna module 2297.

Some of the components may be connected to each other via communication methods between peripherals (such as buses, General Purpose Input and Output (GPIO), Serial Peripheral Interface (SPI), and Mobile Industry Processor Interface (MIPI)) to interchange signals (e.g., commands and/or data).

The command or data may be transmitted or received between the electronic apparatus 2201 and the external electronic apparatus 2204 through the server 2108 connected to the second network 2299. Other electronic apparatuses 2202 and 2204 may be the same or different types of apparatuses as the electronic apparatus 2201. All or some of the operations executed in the electronic apparatus 2201 may be executed in one or more of the other electronic apparatuses 2202, 2204, and 2208. For example, when the electronic apparatus 2201 needs to perform a function or service, it may request one or more other electronic apparatuses to perform part or all of the function or service instead of executing the function or service on its own. One or more other electronic apparatuses receiving the request may execute an additional function or service related to the request and transmit a result of the execution to the electronic apparatus 2201. To this end, cloud computing, distributed computing, and/or client-server computing technology may be used.

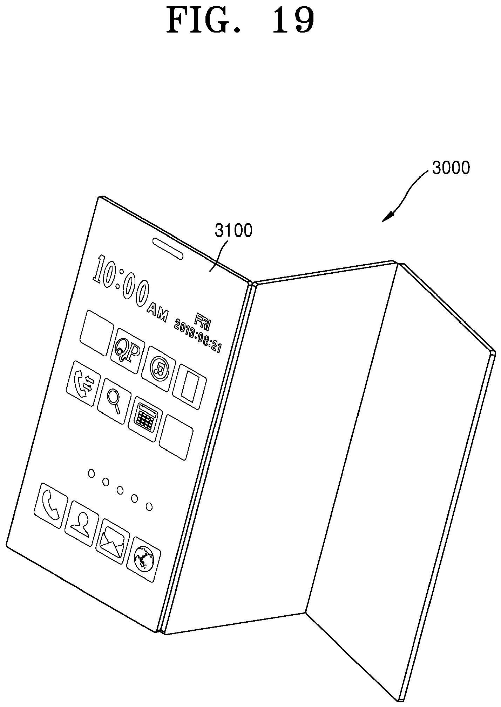

FIG. 19 illustrates an example in which a display apparatus according to an embodiment is applied to a mobile apparatus 3000. The mobile apparatus 3000 may include a display apparatus 3100. The display apparatus 3100 may include a display apparatus 100 according to an embodiment. The display apparatus 3100 may have a foldable structure, and may be implemented into, for example, a multi-folder display. Although the mobile apparatus 3000 has been illustrated as including a folder type display, the mobile apparatus 3000 may include a flat panel display.

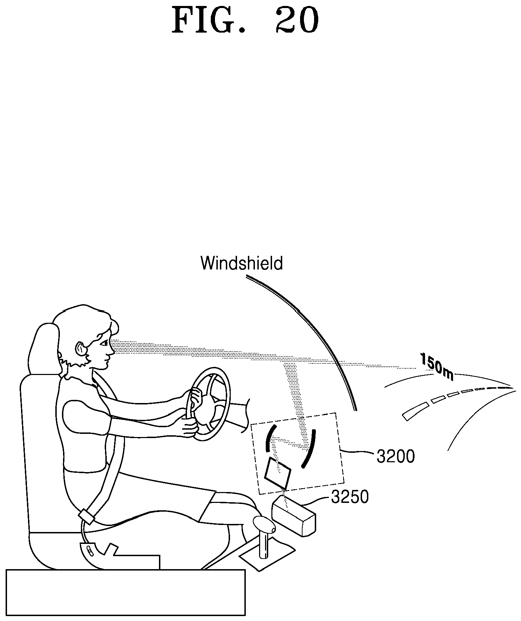

FIG. 20 illustrates an example in which a display apparatus according to an embodiment is applied to a vehicle. The display apparatus may be implemented as a head-up display apparatus for a vehicle. The head-up display apparatus may include a display device 3250 provided in one area of a vehicle and at least one optical path changing member 3200 that converts a path of light so that a driver may view an image generated by the display apparatus 3250. The display apparatus 3250 may include a display apparatus 100 according to an embodiment.

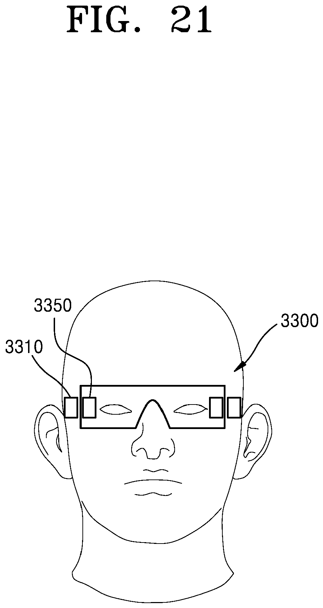

FIG. 21 illustrates an example in which a display apparatus according to an embodiment is applied to augmented reality glasses or virtual reality glasses. The augmented reality glasses or virtual reality glasses 3300 may include a projection system 3310 that forms an image and at least one element 3350 that guides the image from the projection system 3310 to enter a user's eyes. The projection system 3310 may include a display apparatus 100 according to an embodiment.

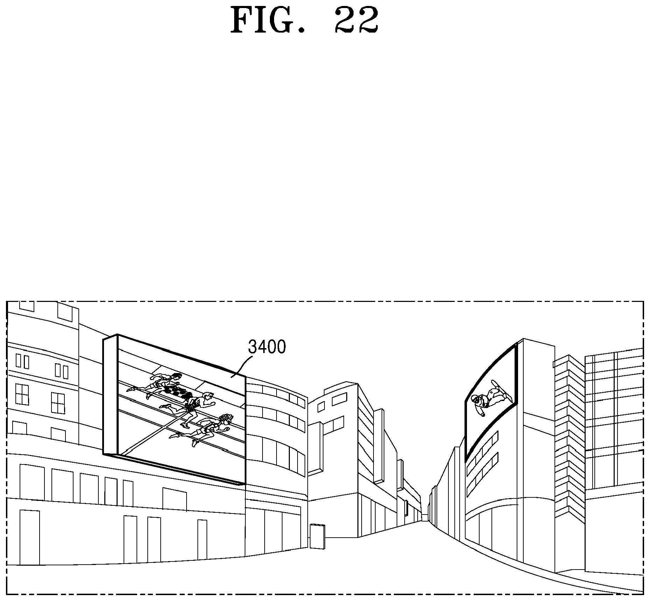

FIG. 22 illustrates an example in which a display apparatus according to an embodiment is applied to a large signage. The signage 3400 may be used for outdoor advertising using a digital information display, and may control advertising content, etc. through a communication network. For example, the signage 3400 may be implemented by applying the display apparatus 100 according to an embodiment.

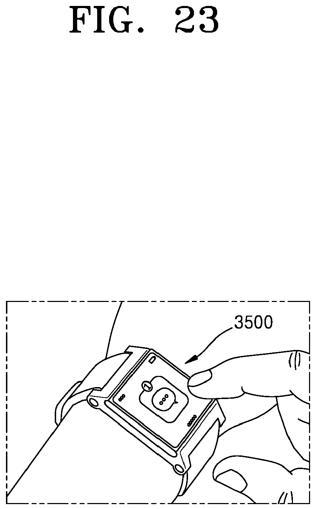

FIG. 23 illustrates an example in which a display apparatus according to an embodiment is applied to a display on a wearable apparatus. The display 3500 of the wearable apparatus may be implemented by applying the display apparatus 100 according to an embodiment.

The display apparatus 100 in accordance with an embodiment may be applied to various products, such as a rollable TV, a stretchable display, and the like.

According to the display apparatus and the method of manufacturing the same according to the embodiment, since the light emitting devices of the plurality of sub-pixels form a vertical stack of an epitaxial structure including the carrier blocking layers between the first semiconductor layers and the active layers on one growth substrate, and are formed in a monolithic form by an etching process, a high-level transfer technology is not required to form the display apparatus.

In addition, according to the display apparatus and the method of manufacturing the same according to the embodiment, a manufacturing process of the color conversion layer for color implementation may be omitted.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light emitting structure comprising:
a substrate;
a first epitaxial structure disposed on the substrate;
a second epitaxial structure disposed on the first epitaxial structure; and
a third epitaxial structure disposed on the second epitaxial structure;
wherein each of the first epitaxial structure, the second epitaxial structure, and the third epitaxial structure comprises, in a sequentially stacked structure, a first semiconductor layer of a first conductivity, a carrier blocking layer, an active layer, and a second semiconductor layer of a second conductivity.

2. The light emitting structure of claim 1, wherein the carrier blocking layer comprises a hole blocking layer.

3. The light emitting structure of claim 2, wherein each of the first epitaxial structure, the second epitaxial structure, and the third epitaxial structure further comprises an electron blocking layer between the active layer and the second semiconductor layer.

4. The light emitting structure of any preceding claim, further comprising a first junction layer and a second junction layer each doped with a high concentration to have the first conductivity, respectively between the first epitaxial structure and the second epitaxial structure, and between the second epitaxial structure and the third epitaxial structure.

5. The light emitting structure of any preceding claim, wherein the active layer of each of the first epitaxial structure, the second epitaxial structure, and the third epitaxial structure is configured to emit light at different wavelengths.

6. A display apparatus comprising:
a plurality of light emitting devices including a first surface from which light is emitted; and a plurality of light emitting structures according to any preceding claim spaced apart from each other on a second surface opposite to the first surface, each of the plurality of light emitting structures being configured to emit light of different wavelengths,
wherein the first surface corresponds to one surface of the first semiconductor layer of the first epitaxial structure; and
wherein the plurality of light emitting devices are formed in a monolithic shape connected through a partial thickness part of the first semiconductor layer of the first epitaxial structure.

7. The display apparatus of claim 6, further comprising a common electrode disposed on the first surface, and optionally wherein the common electrode is patterned to form, on the first surface, a plurality of opening regions configured to emit light generated from the plurality of light emitting devices, and further optionally comprising a light extraction pattern in at least a portion of the plurality of opening regions.

8. The display apparatus of claim 6 or 7, wherein each of the plurality of mesa structures further comprises a first electrode in contact with the second semiconductor layer of the first epitaxial structure or the at least one of the second epitaxial structure that is farthest from the first surface, and optionally wherein the first electrode comprises a transparent electrode disposed on a surface of the second semiconductor layer.

9. The display apparatus of any of claims 6 to 8, wherein the width of each of the plurality of light emitting structures is in the range of 0.1 µm to 100 µm.

10. An augmented reality apparatus comprising:
a projection system including a display apparatus according to any of claims 6 to 9 configured to generate an image; and
an optical system for guiding the image from the projection system to a user's eyes.

11. A method of manufacturing a display apparatus, the method comprising:
vertically stacking a plurality of epitaxial structures each having a sequentially stacked structure of a first semiconductor layer of a first conductivity, a carrier blocking layer, an active layer, and a second semiconductor layer of a second conductivity on a growth substrate to form a vertical stack of a first epitaxial structure of the plurality of epitaxial structures and at least one second epitaxial structure of the plurality of epitaxial structures, each of the active layers of the plurality of epitaxial structures having a different emission wavelength;
etching to a part of the depth of the first semiconductor layer of the first epitaxial structure with respect to the vertical stack to form a plurality of mesa structures spaced apart from each other;
removing at least one epitaxial structure from at least one mesa structure of the plurality of mesa structures so that at least two mesa structures of the plurality of mesa structures have different heights; and
removing the growth substrate to expose a first surface of the first semiconductor layer of the first epitaxial structure,
wherein the display apparatus is configured to emit light is through the first surface, and the plurality of mesa structures are spaced apart from each other on the second surface opposite to the first surface to form a plurality of light emitting devices that are each configured to emit light at different wavelengths,
wherein the plurality of light emitting devices are formed in a monolithic shape connected through a partial thickness part of the first semiconductor layer of the first epitaxial structure, and
wherein the carrier blocking is configured to block a carrier moving from the second semiconductor layer toward the first semiconductor layer such that each of the plurality of mesa structures is configured to generate colored light of the corresponding light emitting device of the plurality of light emitting devices in the active layer of the epitaxial structure of the plurality of epitaxial structures farthest from the first surface.

12. The method of manufacturing the display apparatus of claim 11, further comprising forming a high-concentration doped junction layer to have the first conductivity on the second semiconductor layer of at least one epitaxial structure of the plurality of epitaxial structures to form a tunnel junction between epitaxial structures that are adjacent to each other in a vertical direction.

13. The method of manufacturing the display apparatus of claim 11 or 12, further comprising forming a plurality of driving transistors for driving each of the plurality of light emitting devices by being electrically connected to each of the plurality of mesa structures before removing the growth substrate, to form the plurality of driving transistors and the plurality of light emitting devices in a monolithic manner.

14. The method of manufacturing the display apparatus of any of claims 11 to 13, further comprising forming a common electrode patterned to form a plurality of opening regions through which light is configured to pass on the first surface of the first semiconductor layer of the first epitaxial structure exposed by removing the growth substrate, and optionally further comprising forming a light extraction pattern in the opening region.

15. The method of manufacturing the display apparatus of any of claims 11 to 14, further comprising forming a first electrode in contact with the second semiconductor layer of the first epitaxial structure or the at least one of the second epitaxial structure that is farthest from the first surface of each of the plurality of mesa structures.
